# EUROPÄISCHE PATENTSCHRIFT

(11) **EP 2 766 740 B1**
(45) Veröffentlichungstag und Bekanntmachung des Hinweises auf die Patenterteilung: **07.01.2015**
(21) Anmeldenummer: 12751339.8
(22) Anmeldetag: 28.08.2012
(51) Int. Cl.: G01R 33/07, G01R 33/00

(54) **HALL-SENSOR**
HALL SENSOR
CAPTEUR HALL

(30) Priorität: 10.10.2011 DE 102011115566
(43) Veröffentlichungstag der Anmeldung: 20.08.2014
(73) Patentinhaber: AMS AG, 8141 Unterpremstätten (AT)
(72) Erfinder: RÖHRER, Georg, A-8403 Lebring (AT)
(74) Vertreter: Epping - Hermann - Fischer
(86) Internationale Anmeldenummer: PCT/EP2012/066697
(87) Internationale Veröffentlichungsnummer: WO 2013/053534

(56) Entgegenhaltungen:
- US-A1- 2007 046 287

## Beschreibung

Die Erfindung betrifft einen Hall-Sensor mit mehreren Hall-Sensorelementen, die auf einem Halbleiterkörper angeordnet sind.

Der nach dem amerikanischen Physiker Edwin Herbert Hall (1855 - 1938) benannte Hall-Effekt tritt auf, wenn ein Magnetfeld senkrecht zu einem elektrischen Strom vorhanden ist. Das Magnetfeld erzeugt in diesem Fall eine Potenzialdifferenz, die als Hall-Spannung bezeichnet wird, in einer Richtung, die senkrecht sowohl zu der Richtung des Magnetfeldes als auch zu der Richtung des Stromes verläuft. Durch eine Messung der Hall-Spannung ist es möglich, die Größe der betreffenden Komponente des Magnetfeldes zu bestimmen.

Ein zur Messung einer Hall-Spannung vorgesehener Hall-Sensor kann als Halbleiterbauelement realisiert werden. In dem Halbleiterbauelement kann auch eine Auswerteschaltung integriert sein, die zum Beispiel im Rahmen eines CMOS-Prozesses hergestellt werden kann. Wenn die Ebene des aktiven Bereiches, in dem der Betriebsstrom fließt und die Hall-Spannung auftritt, koplanar zur Oberseite des Halbleiterkörpers angeordnet ist, kann eine Hall-Spannung gemessen werden, die von einer senkrecht zu der Oberseite gerichteten Komponente des Magnetfeldes hervorgerufen wird. Wenn die Ebene des aktiven Bereiches senkrecht zur Oberseite, das heißt, vertikal innerhalb des Halbleiterkörpers, angeordnet ist, kann eine Hall-Spannung gemessen werden, die von einer parallel zu der Oberseite gerichteten Komponente des Magnetfeldes hervorgerufen wird.
Bei Hall-Sensor-Halbleiterbauelementen ist die erreichbare Empfindlichkeit durch die Mobilität der Ladungsträger in dem verwendeten Halbleitermaterial beschränkt. In Silizium liegt die maximale Empfindlichkeit eines Hall-Sensors, gemessen durch die Größe der Hall-Spannung bezogen auf die Stärke des Magnetfeldes und die Betriebsspannung, etwa bei 0,1 V/T. Andere Halbleitermaterialien bieten eine höhere Ladungsträgermobilität, sind aber für eine Integration des Hall-Sensors mit der Ansteuer- und Auswerteelektronik weniger geeignet.

Hall-Sensoren weisen üblicherweise eine nicht vernachlässigbare Offset-Spannung auf Eine solche Offset-Spannung ist die Spannung, die zwischen zwei Anschlusskontakten des Hall-Sensors messbar ist, ohne dass ein externes magnetisches Feld am Hall-Sensor vorliegt.

In dem Lehrbuch von R. S. Popovic, "Hall Effect Devices", zweite Auflage, Institute of Physics Publishing, Bristol und Philadelphia 2004, werden in dem Abschnitt 5.6.3 auf den Seiten 282 bis 286 Verfahren beschrieben, mit denen die Offset-Spannung reduziert werden kann. Dazu gehören auch die Verfahren der rotierenden Betriebsströme (Spinning-Current-Technik) und der Paarung (Pairing).

Die verbleibende Offset-Spannung nach Anwendungen dieser Verfahren wird Restoffset-Spannung, englisch: residual offset voltage, genannt. Bezogen auf die Empfindlichkeit des Hall-Sensors verbleiben aber auch bei Anwendung der beschriebenen Verfahren Restoffset-Spannungen, die größer sind als solche Spannungen, die aus dem Erdmagnetfeld resultieren. Dementsprechend begrenzt die Restoffset-Spannung die Genauigkeit des Hall-Sensors.

Das Dokument US 2007/046287 A1 beschreibt ein Verfahren und eine Anordnung zur Detektierung räumlich variierender und zeitabhängiger magnetischer Felder. Dazu wird ein Array mit einzelnen Hall-Sensoren vorgesehen, welche geometrisch innerhalb einer Rechteckform angeordnet sind. Für jede Zeile in diesem Array werden alle Hall-Sensoren der Zeile mit einem gleichen Versorgungssignal versorgt. Ferner sind in jeder Spalte die entsprechenden Anschlüsse der Hall-Sensoren, an denen eine Hall-Spannung abgreifbar ist, über Transistorschalter parallel an einen Operationsverstärker für die Spalte angeschlossen. Die Schalttransistoren werden wiederum zeilenweise angesteuert. Durch die Art der Verschaltung wird erreicht, dass jeder Hall-Sensor in der rechteckförmigen Anordnung einzeln ausgewertet werden kann.

Eine zu lösende Aufgabe besteht darin, einen Hall-Sensor mit hoher Empfindlichkeit und niedriger Offset-Spannung anzugeben.

Diese Aufgabe wird durch den Gegenstand des unabhängigen Patentanspruchs gelöst. Weiterbildungen und Ausgestaltungsformen sind in den abhängigen Ansprüchen gekennzeichnet.

Beispielsweise werden für einen Hall-Sensor drei oder mehr Hall-Sensorelemente, die vorzugsweise gleichartig ausgeführt sind, auf einem Halbleiterkörper angeordnet und mit entsprechenden internen Anschlüssen der Hall-Sensorelemente untereinander sowie mit externen Anschlüssen des Hall-Sensors verbunden. Jedoch sind nicht alle internen Anschlüsse der Hall-Sensorelemente auch nach außen, das heißt zu den externen Anschlüssen des Hall-Sensors geführt, sondern teilweise erfolgt eine Verbindung der internen Anschlüsse nur zwischen den einzelnen Hall-Sensorelementen. Über wenigstens drei der externen Anschlüsse lässt sich der Hall-Sensor wie ein üblicher Hall-Sensor kontaktieren und betreiben, sodass die Zahl und Anordnung der Hall-Sensorelemente nach außen hin unberücksichtigt bleiben kann.

Die internen Anschlüsse können auch als Elementanschlüsse bezeichnet werden, während die externen Anschlüsse auch Sensoranschlüsse genannt werden können.

Beispielsweise dienen zwei der Sensoranschlüsse zur Zuführung eines Versorgungssignals, etwa eines Versorgungsstroms, des Hall-Sensors, während wenigstens ein weiterer Sensoranschluss zum Abgreifen eines Messsignals, etwa einer Messspannung dient. Insbesondere sind die Elementanschlüsse der Hall-Sensorelemente regelmäßig nicht direkt von außen ankoppelbar, sondern lediglich über die jeweiligen Sensoranschlüsse. Mit anderen Worten sind Elementanschlüsse unter anderem dadurch definiert, dass über diese kein Versorgungssignal, etwa ein Versorgungsstrom, an den Hall-Sensor zugeführt wird. Wenn einzelne Elementanschlüsse von Hall-Sensorelementen auf Anschlüsse nach außen geführt sind, sind diese Anschlüsse nur dann als Sensoranschlüsse zu verstehen, wenn diese im Betrieb, insbesondere zu einem Betriebszeitpunkt im Messbetrieb, des Hall-Sensors zur Kontaktierung des Hall-Sensors benötigt beziehungsweise verwendet werden. Wenn aber ein nach außen geführter Elementanschluss nur für interne Zwecke, beispielsweise eine Messung in dem Hall-Sensor, verwendet wird, so ist ein solcher Anschluss als zusätzlicher Hilfsanschluss des Hall-Sensors zu verstehen.

Die Sensoranschlüsse sind funktional dadurch definiert, dass die Vielzahl der miteinander verschalteten Hall-Sensorelemente über die Sensoranschlüsse wie ein einzelner Hall-Sensor kontaktierbar ist. Insofern unterscheiden sich die Sensoranschlüsse von optional nach außen geführten Elementanschlüssen. Insbesondere sind die Sensoranschlüsse für eine Kontaktierung des Hall-Sensors im Betrieb eingerichtet.

Durch das Vorsehen der mehreren Hall-Sensorelemente und durch die entsprechende Verschaltung kann die Restoffset-Spannung bei verbesserter Genauigkeit reduziert werden. Dieser Effekt basiert beispielsweise darauf, dass durch die Verschaltung der Hall-Sensorelemente ein elektrisches Feld in einem einzelnen Hall-Sensorelement reduziert ist, da die an den Sensoranschlüssen angelegte Betriebsspannung sich auf mehrere Hall-Sensorelemente verteilt.

Unter gleichartigen Hall-Sensorelementen wird verstanden, dass diese zumindest teilweise gleiche Eigenschaften aufweisen. Beispielsweise weisen die Hall-Sensorelemente eine gleiche Anzahl von Elementanschlüssen auf und/oder haben gleiche geometrische Dimensionen. In verschiedenen Ausführungsformen können auch Hall-Sensorelemente miteinander verschaltet werden, die nicht gleichartig sind.

In einer Ausführungsform umfasst ein Hall-Sensor wenigstens drei Hall-Sensorelemente, insbesondere gleichartige Hall-Sensorelemente, die jeweils wenigstens drei Elementanschlüsse aufweisen und in einem Gitter, insbesondere einem Schaltungsgitter, mit einer mehr als eindimensionalen Struktur verschaltet sind, sowie wenigstens drei Sensoranschlüsse zur Kontaktierung des Hall-Sensors. Jeder Sensoranschluss ist zumindest mit einem der Hall-Sensorelemente an einem von dessen Elementanschlüssen verbunden.

Durch das Gitter ist eine zweidimensionale beziehungsweise mehrdimensionale Verschaltung von Hall-Sensorelementen erreicht. Zudem ist durch das Gitter beispielsweise eine Array-artige Verschaltung gebildet. Mit anderen Worten wird von den gitterartig verschalteten Hall-Sensorelementen zumindest eine Ebene aufgespannt.

Beispielsweise ist eine Vielzahl der Hall-Sensorelemente in einem N x M Gitter bzw. Array angeordnet, wobei N größer als 1 und M größer als 1 sind. M und N können gleich oder unterschiedlich sein. Beispielsweise sind N und M eine Exponentialzahl zur Basis 2. Bei drei Hall-Sensorelemente erfolgt eine Verschaltung beispielsweise über Eck, sodass in einem 2 x 2-Gitter ein Gitterplatz unbelegt ist. Das Gitter ist beispielsweise ein 8 x 8, ein 16 x 16, ein 32 x 32 oder auch ein größeres Gitter mit einer entsprechenden Anzahl von Hall-Sensorelementen. Die höhere Anzahl der Hall-Sensorelemente ermöglicht es, die Off-set-Spannung beziehungsweise die Restoffset-Spannung weiter zu reduzieren. Das Gitter muss nicht vollständig gefüllt sein, so dass auch einzelne Knoten des Gitters frei bleiben können. Dementsprechend lassen sich auch Verschaltungsgitter bilden, welche eine andere als eine rechteckige Form aufweisen, beispielsweise eine runde oder kreuzförmige oder vieleckige Form. Durch die Verschaltung in dem Gitter wird eine zweidimensionale oder eine mehrdimensionale Verschaltung der Hall-Sensorelemente erreicht.

Die einzelnen Hall-Sensorelemente sind in dem Gitter in einigen Ausführungsformen so angeordnet, dass sich eine oder mehrere Spalten beziehungsweise Zeilen des Gitters mit benachbarten Spalten beziehungsweise Zeilen überlappen, ohne dass sich jedoch die Hall-Sensorelemente zwingend gegenseitig überlappen. Beispielsweise sind die Hall-Sensorelemente in einer wabenförmigen Gitterstruktur verschaltet.

In einer Ausführungsform ist das Gitter eine mehr als ein-dimensionale Matrix. Eine ein-dimensionale Matrix könnte beispielsweise durch eine reine Serienschaltung von mehreren Hall-Sensorelementen realisiert sein.

In dem Gitter ist beispielsweise jedes Hall-Sensorelement durch eine zweidimensionale oder mehrdimensionale Koordinate, beispielsweise durch ein Koordinatenpaar, gekennzeichnet.

Beispielsweise ist in einer Ausführungsform ein Hall-Sensor mit wenigstens drei Hall-Sensorelementen, insbesondere gleichartigen Hall-Sensorelementen, derart verschaltet, dass in jeder möglichen Kombination von jeweils zwei der Sensoranschlüsse wenigstens ein Signalpfad zwischen diesen zwei Sensoranschlüssen gebildet ist, bei dem eine Anzahl von Hall-Sensorelementen, die in diesem Signalpfad verbunden sind, kleiner als die gesamte Anzahl der Hall-Sensorelemente des Hall-Sensors ist.

Dementsprechend ist es möglich, dass ein Hall-Sensorelement beispielsweise mit zwei Sensoranschlüssen verbunden ist, wobei solche zwei Verbindungen an unterschiedlichen Elementanschlüssen erfolgen. Weiterhin kann jeder Sensoranschluss auch mit mehreren Hall-Sensorelementen verbunden sein. Eine reine Parallelschaltung oder eine reine Serienschaltung von Hall-Sensorelementen bezüglich der Sensoranschlüsse ist somit nicht vorgesehen.

Von einem beliebigen Sensoranschluss des Hall-Sensors zu einem weiteren beliebigen Anschluss des Hall-Sensors lassen sich durch die Verschaltung der verschiedenen Hall-Sensorelemente in der Regel mehrere Signalpfade finden, die durch eine bestimmte Anzahl von Hall-Sensorelementen laufen. Die Hall-Sensorelemente des vorliegenden Hall-Sensors sind dabei so verschaltet, dass eine gitterförmige oder arrayartige Verschaltung vorliegt.

Insbesondere sind die Hall-Sensorelemente auch nicht in einer reinen Serienschaltung angeordnet. Dementsprechend lässt sich bei dem vorliegenden Hall-Sensor jeweils immer wenigstens ein Signalpfad finden, der zwei Sensoranschlüsse über eine Zahl von Hall-Sensorelementen verbindet, die geringer ist als die Gesamtanzahl der Hall-Sensor-elemente des Hall-Sensors. Wenn mehrere Hall-Sensorelemente funktional zu einem einzigen Hall-Sensorelement zusammengeschaltet sind, welches dann in dem Hall-Sensor verschaltet ist, ergibt sich ein jeweiliger Signalpfad jeweils nur durch dieses einzige Hall-Sensorelement, nicht aber durch dessen Bestandteile. Beispielsweise gelten zwei vollständig parallel geschaltete Hall-Sensorelemente als ein einziges Hall-Sensorelement.

Die Sensoranschlüsse werden beispielsweise paarweise verwendet, um an einem Paar ein Versorgungssignal anzulegen und an einem anderen Paar ein Messsignal aufzunehmen. Entsprechend der beschriebenen Verschaltung durchlaufen sowohl das Versorgungssignal als auch das Messsignal jeweils mehrere Hall-Sensorelemente, wodurch sich eine reduzierte Restoffset-Spannung ergibt.

In verschiedenen Ausführungsformen ist bei wenigstens zwei oder bei allen der Hall-Sensorelemente wenigstens ein Elementanschluss, der nicht mit einem Sensoranschluss verbunden ist, mit einem anderen, insbesondere benachbarten Hall-Sensorelement an genau einem von dessen Elementanschlüssen verbunden, der nicht mit einem Sensoranschluss verbunden ist. Dies gilt insbesondere jeweils für einen bestimmten Betriebszeitpunkt des Hall-Sensors, in dem der Hall-Sensor über bestimmte Sensoranschlüsse kontaktiert wird.

In einer Ausführungsform ist der Hall-Sensor derart gestaltet, dass höchstens zwei Elementanschlüsse eines jeden Hall-Sensorelements jeweils mit einem der Sensoranschlüsse verbunden sind. Dadurch wird erreicht, dass je nach Anzahl der Hall-Sensorelemente, die von dem Hall-Sensor umfasst sind, keine Kontaktierung eines Hall-Sensorelements zu einem Sensoranschluss oder genau eine Kontaktierung von einem Elementanschluss zu einem Sensoranschluss oder genau zwei Kontaktierungen von zwei unterschiedlichen Elementanschlüssen eines Hall-Sensorelements zu zwei unterschiedlichen Sensoranschlüssen besteht. Insbesondere bei einer größeren Anzahl von Hall-Sensorelementen sind beispielsweise die innen liegenden Hall-Sensorelemente nicht mit den Sensoranschlüssen verbunden, sodass nur außen liegende Hall-Sensorelemente die Sensoranschlüsse kontaktieren. In Abhängigkeit von der Anordnung der verschiedenen Hall-Sensorelemente ist beispielsweise nur jeweils ein Elementanschluss des Hall-Sensorelements mit einem Sensoranschluss verbunden, der beispielsweise zentral an einer Außenseite liegt. Bei kleineren Anordnungen können Hall-Sensorelemente, die an Ecken beziehungsweise Übergangsbereichen zwischen zwei Sensoranschlüssen liegen, auch mit zwei Sensoranschlüssen verbunden sein.

In einigen bevorzugten Ausführungsformen ist bei allen Hall-Sensorelementen wenigstens ein Elementanschluss nicht mit einem Sensoranschluss, sondern lediglich mit einem Elementanschluss eines anderen, insbesondere benachbarten Hall-Sensorelements verbunden. Beispielsweise ist dementsprechend bei allen der Hall-Sensorelemente wenigstens ein Elementanschluss, der nicht mit einem Sensoranschluss verbunden ist, mit genau einem Elementanschluss eines benachbarten Hall-Sensorelements verbunden, der nicht mit einem Sensoranschluss verbunden ist. Dadurch kann verbessert eine Verschaltung der Hall-Sensorelemente erfolgen, die zu einer Reduktion der Restoffset-Spannung des Hall-Sensors führt.

In verschiedenen Ausführungsformen sind die Hall-Sensorelemente innerhalb einer definierten Flächenform angeordnet, beispielsweise derart, dass jeweils zwei Hall-Sensorelemente parallel und/oder versetzt zueinander angeordnet sind. Beispielsweise ergibt sich durch die verschiedenen Hall-Sensorelemente ein gleichmäßiges Muster in der Fläche. Die Hall-Sensorelemente sind dementsprechend mit gleicher Orientierung oder bestimmt verdrehter Orientierung definiert in der Fläche angeordnet, um ein günstiges Verhalten bezüglich der Offset-Spannung beziehungsweise der Restoffset-Spannung des Hall-Sensors zu erreichen. Die Orientierung der Hall-Sensorelemente ist beispielsweise durch eine Stromflussrichtung durch das Element oder durch einen geometrischen Aufbau oder durch einen speziellen Aufbau in einer Halbleiterwanne definiert.

Die Flächenform, innerhalb der die Hall-Sensorelemente angeordnet sind, weist beispielsweise wenigstens eine Symmetriebeziehung, beispielsweise eine Achsensymmetrie oder eine Punktsymmetrie auf. Zudem kann die Fläche beispielsweise eine der folgenden, insbesondere symmetrischen Formen aufweisen: Eine Rechteckform, eine quadratische Form, eine Kreuzform, eine Kreisform oder die Form eines geraden Vielecks, beispielsweise eines Sechsecks oder eines Achtecks. Um die beispielsweise auf dem Halbleiterkörper definierte Fläche möglichst günstig ausnutzen zu können, sind Form und Größe der Hall-Sensorelemente an die Form der Fläche des Hall-Sensors angepasst. Beispielsweise ist die Fläche in Bereiche aufgeteilt, in denen jeweils ein in seiner Form angepasstes Hall-Sensorelement angeordnet ist.

Einzelne Hall-Sensorelemente, die insbesondere bei einer großen Zahl von Hall-Sensorelementen über den Rand der Fläche hinausragen, gelten makroskopisch als von der Fläche mit umfasst. Dementsprechend kann in verschiedenen Ausführungsformen auch auf eine strenge Symmetrie der Fläche verzichtet werden. Im Wesentlichen bestimmt die Fläche beziehungsweise eine Zerlegung der Fläche in Teilbereiche die Art der Verschaltung der Hall-Sensorelemente, sodass in verschiedenen Ausführungsformen die Fläche auch als Verschaltungsfläche verstanden werden kann und die tatsächliche Position der Hall-Sensorelemente unabhängig von den Dimensionen der Fläche ist.

In verschiedenen Ausführungsformen sind die Hall-Sensorelemente, die mit den Sensoranschlüssen verbunden sind, jeweils an den Außenrand der Fläche angrenzend angeordnet. Weiterhin sind in verschiedenen Ausführungsformen die Hall-Sensorelemente, die nicht an den Außenrand der Fläche angrenzend angeordnet sind, vorzugsweise an allen ihren Elementanschlüssen jeweils mit genau einem Elementanschluss eines benachbarten Hall-Sensorelements verbunden.

Dementsprechend bilden die Hall-Sensorelemente des Hall-Sensors ein verschaltetes Gitter, welches die Eigenschaften eines jeden Hall-Sensorelements im Einzelnen nutzt und nach außen hin kontaktiert ist wie ein einziger, größerer Hall-Sensor. Vorzugsweise sind die Hall-Sensorelemente, die nicht an den Außenrand der Fläche angrenzend angeordnet sind, an den einzelnen Elementanschlüssen mit jeweils verschiedenen benachbarten Hall-Sensorelementen verbunden. Dementsprechend ist jeder Elementanschluss eines solchen Hall-Sensorelements mit einem anderen benachbarten Hall-Sensorelement verbunden.

Nach außen hin, also zu den Sensoranschlüssen des Hall-Sensors, können einzelne Hall-Sensoren, insbesondere solche, die am Rand der Fläche angrenzend angeordnet sind, kontaktiert werden. Die Zahl der Hall-Sensorelemente, die mit einem der Sensoranschlüsse verbunden ist, kann in verschiedenen Ausführungsformen variabel gestaltet werden, wobei von jedem Sensoranschluss ein Kontakt zu wenigstens einem Hall-Sensorelement hergestellt ist.

In verschiedenen Ausführungsformen ist hierbei wenigstens eine Verbindung von einem der Sensoranschlüsse zu einem der Elementanschlüsse eine feste Verbindung, beispielsweise durch eine feste Verdrahtung oder eine festgelegte Koppelung in dem Halbleiterkörper. Dementsprechend können für jeden der Sensoranschlüsse ein, zwei oder mehrere Hall-Sensorelemente fest mit dem Sensoranschluss verbunden sein.

Weiterhin ist es möglich, dass zusätzlich zu der festen Verbindung die Sensoranschlüsse jeweils wenigstens eine schaltbare Verbindung zu wenigstens einem anderen der Hall-Sensorelemente an genau einem von dessen Elementanschlüssen aufweisen. Vorzugsweise ist eine solche schaltbare Verbindung zu einem solchen Hall-Sensorelement hergestellt, welches benachbart zu einem Hall-Sensorelement angeordnet ist, das ebenfalls mit diesem Sensoranschluss verbunden ist, unabhängig davon, ob diese Verbindung fest oder geschaltet ist.

Je höher die Anzahl der Hall-Sensorelemente ist, die mit einem Sensoranschluss verbunden sind, desto geringer ist der Eingangswiderstand des Hall-Sensors als Ganzes. Dementsprechend steigt der Eingangswiderstand des Hall-Sensors mit sinkender Anzahl von Hall-Sensorelementen, die mit den jeweiligen Sensoranschlüssen verbunden sind. Diese Eigenschaft des Hall-Sensors kann beim Betrieb des Hall-Sensors genutzt werden beziehungsweise an die Anforderungen des Hall-Sensors für eine bestimmte Anwendung angepasst werden. Dementsprechend kann ein Hall-Sensor mit einem definierten Eingangswiderstand bereitgestellt werden. Weiterhin ist es aber möglich, durch die schaltbare Verbindung den Eingangswiderstand des Hall-Sensors im Betrieb zu verändern. Beispielsweise kann in einem Ruhemodus oder Standby-Modus einer Anordnung, die den Hall-Sensor verwendet, eine hochohmige Anschlusskonfiguration des Hall-Sensors eingestellt werden, welche einen niedrigen Strom und damit einen geringen Energieverbrauch bewirkt. Die Genauigkeit des Hall-Sensors ist in diesem Ruhemodus von untergeordneter Bedeutung, genügt aber vorzugsweise den Anforderungen an eine signifikante Messung. In einem normalen Betriebsmodus ist beispielsweise eine höhere Genauigkeit erforderlich, sodass der Hall-Sensor in einer niederohmigen Anschlusskonfiguration betrieben wird. Dazu werden beispielsweise durch die schaltbaren Verbindungen mehr Hall-Sensorelemente mit den Sensoranschlüssen verbunden.

Die Hall-Sensorelemente, die zusammen den Hall-Sensor bilden, können ihrerseits laterale Hall-Sensoren sein, die ein Magnetfeld senkrecht zur Oberfläche des Hall-Sensors messen, oder aber vertikale Hall-Sensoren, welche ein Magnetfeld parallel zur Oberfläche des Hall-Sensors messen. Durch die Zusammenschaltung mehrerer lateraler Hall-Sensorelemente lässt sich dementsprechend ein größerer lateraler Hall-Sensor bilden, welcher wiederum ein magnetisches Feld senkrecht zur Oberfläche der Hall-Sensorelemente misst. Wenn der Hall-Sensor aus einer Vielzahl von vertikalen Hall-Sensorelementen gebildet ist, resultiert ein großer vertikaler Hall-Sensor zur Messung eines Magnetfelds parallel zur Oberfläche des Hall-Sensors. Durch die Vielzahl der Hall-Sensorelemente ist sowohl für laterale als auch für vertikale Hall-Sensorelemente die Genauigkeit beziehungsweise die Empfindlichkeit des Hall-Sensors erhöht, während die Offset-Spannung beziehungsweise Restoffset-Spannung reduziert ist.

Die einzelnen Hall-Sensorelemente können bezüglich technischer beziehungsweise geometrischer Orientierung gleichmäßig oder verdreht zueinander verschaltet werden. Insbesondere hängt die technische Orientierung eines vertikalen Hall-Sensorelements von den jeweiligen Elementanschlüssen ab, die zur Messung kontaktiert werden.

In verschiedenen Ausführungsformen sind die Hall-Sensorelemente beispielsweise gleichartig aufgebaut und weisen jeweils wenigstens vier Elementanschlüsse auf, die durch ein erstes Paar von Elementanschlüssen und wenigstens ein zweites Paar von Elementanschlüssen gebildet sind. Bei zumindest einem Teil der Hall-Sensorelemente ist ein erster Elementanschluss des ersten Paares eines Hall-Sensorelements mit einem der Elementanschlüsse des zweiten Paars eines anderen, insbesondere benachbarten Hall-Sensorelements verbunden. Zudem ist ein erster Elementanschluss des zweiten Paars dieses Hall-Sensorelements mit einem der Elementanschlüsse des ersten Paars eines weiteren anderen, insbesondere benachbarten Hall-Sensorelements verbunden. Sowohl beim Einsatz von vertikalen Hall-Sensorelementen als auch lateralen Hall-Sensorelementen ergibt sich in dieser Ausführungsform eine orientierungsmäßig verdrehte Verschaltung der Hall-Sensorelemente, sodass sich verschiedenartige, gegeneinander laufende Störeffekte in den Hall-Sensorelementen ausgleichen und zu einer Reduktion der Restoffset-Spannung beitragen.

In einer anderen Ausführungsform mit gleichartig aufgebauten Hall-Sensorelementen sind bei zumindest einem Teil der Hall-Sensorelemente ein erster Elementanschluss des ersten Paares eines Hall-Sensorelements mit einem zweiten Elementanschluss des ersten Paars eines anderen, insbesondere benachbarten Hall-Sensorelements verbunden und ein erster Elementanschluss des zweiten Paars dieses Hall-Sensorelements mit einem zweiten Elementanschluss des zweiten Paars eines weiteren anderen, insbesondere benachbarten Hall-Sensorelements verbunden. In dieser Ausführungsform sind die Hall-Sensorelemente technisch vorzugsweise gleichartig zueinander verschaltet. Insbesondere beim Einsatz von vertikalen Hall-Sensorelementen erfolgt somit eine gleichartige Verschaltung, welche im Betrieb des Hall-Sensors vorzugsweise zu einer ähnlichen Stromverteilung in allen Hall-Sensorelementen führt. Bei lateralen Hall-Sensorelementen kann jedoch zusätzlich eine geometrische Verdrehung der Hall-Sensorelemente vorgesehen sein, welche unterschiedliche Effekte in den einzelnen Hall-Sensorelementen bewirkt.

Dementsprechend weisen in verschiedenen Ausführungsformen alle Hall-Sensorelemente bezüglich der Ausrichtung des ersten und zweiten Paars eine gleiche Orientierung auf. Diese entspricht beispielsweise einer gleichmäßigen beziehungsweise gleichartigen Verschaltung aller Hall-Sensorelemente.

In anderen Ausführungsformen weisen die Hall-Sensorelemente bezüglich der Ausrichtung des ersten und zweiten Paars zumindest teilweise eine voneinander abweichende Orientierung auf. Dadurch ergibt sich insbesondere der Effekt einer verdrehten Verschaltung der einzelnen Hall-Sensorelemente in dem Hall-Sensor.

Bei einer verdrehten Verschaltung sind die einzelnen Hall-Sensorelemente in dem Hall-Sensor beispielsweise so angeordnet und derart mit den Sensoranschlüssen verbunden, dass unabhängig davon, welches Paar von Sensoranschlüssen im Betrieb des Hall-Sensors kontaktiert wird, eine identische oder nahezu identische Stromverteilung in dem Hall-Sensor entsteht. Am Beispiel von lateralen Hall-Sensorelementen ist dies beispielsweise dadurch gegeben, dass bei einer angenommenen quadratischen Fläche des Hall-Sensors die Hall-Sensorelemente derart orientiert in der Fläche angeordnet sind, dass bei einer 90°-Drehung des Hall-Sensors ein identisches oder nahezu identisches Bild bezüglich der Verdrehung der einzelnen Hall-Sensorelemente entsteht. Dementsprechend ist beispielsweise jeder Quadrant der quadratischen Fläche gleichartig aufgebaut, mit einer entsprechenden 90°-Drehung zum benachbarten Quadranten. Dadurch lässt sich ein Hall-Sensor mit hoher Symmetrie und dadurch verbesserter Genauigkeit erreichen. Die Symmetrie ergibt sich durch eine schaltungstechnische Symmetrie oder auch durch eine geometrische Symmetrie der Form des Hall-Sensors.

In weiteren Ausführungsformen mit gleichartig aufgebauten Hall-Sensorelementen sind wenigstens vier Hall-Sensorelemente von dem Hall-Sensor umfasst, die jeweils einen ersten, einen zweiten, einen dritten und einen vierten Elementanschluss aufweisen. Bei mindestens einer Gruppe von vier der Hall-Sensorelemente ist eine gemeinsame Verbindung des ersten Elementanschlusses eines ersten Hall-Sensorelements der Gruppe, des zweiten Elementanschlusses eines zweiten Hall-Sensorelements der Gruppe, des dritten Elementanschlusses eines dritten Hall-Sensorelements der Gruppe und des vierten Elementanschlusses eines vierten Hall-Sensorelements der Gruppe gebildet. Dementsprechend sind zumindest teilweise jeweils verschiedene Elementanschlüsse von vier Hall-Sensorelementen zusammengeschaltet. Eine solche Verschaltung ergibt sich beispielsweise anschaulich bei einer Verschaltung von lateralen Hall-Sensorelementen durch eine entsprechende Kontaktierung an den Ecken der Hall-Sensorelemente. Bei Verwendung von vertikalen Hall-Sensorelementen erfolgt die Verschaltung in entsprechender Weise. Die vier Hall-Sensorelemente einer Gruppe sind beispielsweise benachbart angeordnet.

In einer abgewandelten Ausführungsform ist bei mindestens einer Gruppe von vier der Hall-Sensorelemente eine gemeinsame Verbindung des jeweils ersten Elementanschlusses der Hall-Sensorelemente der Gruppe gebildet. Dementsprechend sind zumindest teilweise jeweils gleiche Elementanschlüsse von vier Hall-Sensorelementen zusammengeschaltet. Die vier Hall-Sensorelemente einer Gruppe sind beispielsweise wiederum benachbart angeordnet. Alternativ ist bei mindestens einer Gruppe von vier der Hall-Sensorelemente eine gemeinsame Verbindung des ersten Elementanschlusses eines ersten Hall-Sensorelements der Gruppe, des dritten Elementanschlusses eines zweiten Hall-Sensorelements der Gruppe, des ersten Elementanschlusses eines dritten Hall-Sensorelements der Gruppe und des dritten Elementanschlusses eines vierten Hall-Sensorelements der Gruppe gebildet. Dementsprechend sind zumindest teilweise jeweils zwei gleiche Elementanschlüsse von zwei Hall-Sensorelementen mit zwei jeweils gleichen Elementanschlüssen von zwei anderen Hall-Sensorelementen zusammengeschaltet. Bei Verwendung von lateralen Hall-Sensorelementen können diese beispielsweise auch geometrisch zueinander verdreht sein.

In einer Ausführungsform umfasst der Hall-Sensor wenigstens vier Hall-Sensorelemente, die jeweils wenigstens drei Elementanschlüsse aufweisen, und einen ersten, einen zweiten, einen dritten und einen vierten Sensoranschluss, insbesondere genau vier Sensoranschlüsse. Jeweils zwei der Sensoranschlüsse bilden miteinander ein erstes und ein zweites Paar. Die Hall-Sensorelemente sind hierbei derart verschaltet, insbesondere mit einer punktsymmetrischen Verschaltung, dass ein elektrisches Verhalten zwischen den Anschlüssen des ersten Paars identisch zu einem elektrischen Verhalten zwischen den Anschlüssen des zweiten Paars ist.

Die Symmetrie ergibt sich beispielsweise dadurch, dass in dem Hall-Sensor schaltungstechnisch vier Quadranten gebildet sind, wobei jeder Quadrant bis auf eine geometrische Verdrehung von Hall-Sensorelementen oder eine schaltungstechnische Rotation von Elementanschlüssen der Hall-Sensorelemente identisch aufgebaut ist. Dementsprechend kann bei einer so genannten Drehung des Hall-Sensorelements ein gleicher Schaltungsaufbau an den gedrehten Anschlüssen entstehen, wie er vor der Drehung an den anderen Anschlüssen vorgelegen hat.

In einer anderen Ausführungsform umfasst der Hall-Sensor wenigstens drei Hall-Sensorelemente, die jeweils drei Elementanschlüsse aufweisen, und einen ersten, einen zweiten und einen dritten Sensoranschluss, insbesondere genau drei Sensoranschlüsse. Eine jeweilige Kombination aus zwei der Sensoranschlüsse bildet miteinander ein erstes, ein zweites und ein drittes Paar. Die Hall-Sensorelemente sind hierbei derart verschaltet, insbesondere mit einer symmetrischen Verschaltung, dass ein elektrisches Verhalten zwischen den Anschlüssen des ersten, des zweiten und des dritten Paars identisch ist.

In verschiedenen Ausführungsformen umfasst jedes Hall-Sensorelement funktional genau ein Hall-Sensorelement oder eine Kombination mehrerer verschalteter Hall-Sensorelemente. Insbesondere kann jedes der Hall-Sensorelemente wiederum durch einen Hall-Sensor gemäß einer der beschriebenen Ausführungsformen gebildet sein. Jedoch ist es auch möglich, dass ein funktionales Hall-Sensorelement durch Parallelschaltung oder eine andere Verschaltung mehrerer einzelner Hall-Sensorelemente gebildet ist. Weiterhin sind auch andere Verschaltungsformen aus mehreren der Hall-Sensoren der beschriebenen Ausführungsformen möglich. Auch lässt sich ein Hall-Sensor gemäß einer der beschriebenen Ausführungsformen wie ein herkömmlicher Hall-Sensor in beliebigen Ansteuerungsvarianten oder Betriebsvarianten betreiben.

Die Hall-Sensoren, die in verschiedenen Ausführungsformen beschrieben sind, lassen sich ohne Weiteres mit den eingangs beschriebenen Verfahren wie Current Spinning Technologie oder Pairing betreiben, da der Hall-Sensor unabhängig von der Anzahl der umfassten Hall-Sensorelemente nur wie ein einziger Hall-Sensor wirkt und kontaktiert wird.

Insbesondere beim Einsatz von vertikalen Hall-Sensorelementen können diese mit geringen Dimensionen und insbesondere einer geringen Wannentiefe ausgeführt werden, um Hall-Sensorelemente mit hoher Genauigkeit zu erhalten. Dementsprechend kann auf diese Weise ein größerer vertikaler Hall-Sensor hergestellt werden, der eine vergleichsweise erhöhte Genauigkeit aufweist und dennoch keine große Wannentiefe benötigt. Dies ist auch für den Herstellungsprozess vorteilhaft.

Wenn mit zwei vertikalen Hall-Sensoren Magnetfelder gemessen werden sollen, die in einem Winkel zueinander verlaufen, beispielsweise im rechten Winkel zueinander, und parallel zur Oberfläche des Hall-Sensors verlaufen kann ebenfalls das in den obigen Ausführungsformen beschriebene Prinzip der Verschaltung einzelner Hall-Sensorelemente genutzt werden. Insbesondere können dabei die vertikalen Hall-Sensorelemente in einem gleichen Bereich des Halbleiterkörpers, nur mit unterschiedlicher geometrischer Orientierung angeordnet werden, wobei ein Teil der Hall-Sensorelemente zu einem Hall-Sensor und der übrige Teil der Hall-Sensorelemente zu dem anderen Hall-Sensor gehören. Dementsprechend kann auf diese Weise eine zweidimensionale Magnetfelderfassung auf demselben Bereich des Halbleiterkörpers erfolgen.

Die Erfindung wird nachfolgend an mehreren Ausführungsbeispielen anhand von Figuren näher erläutert. Gleiche Bezugszeichen kennzeichnen hierbei Elemente oder Bauteile gleicher Funktion. Soweit sich Schaltungsteile oder Bauelemente in ihrer Funktion entsprechen, wird deren Beschreibung nicht in jeder der folgenden Figuren wiederholt.

Es zeigen:
- Figur 1: Ausführungsformen eines Hall-Sensors mit mehreren Hall-Sensorelementen,
- Figur 2: eine schematische Darstellung einer Ausführungsform eines Hall-Sensors,
- Figur 3: Ausführungsformen eines Hall-Sensorelements,
- Figur 4: eine weitere Ausführungsform eines Hall-Sensors mit mehreren Hall-Sensorelementen,
- Figur 5: eine weitere Ausführungsform eines Hall-Sensors mit mehreren Hall-Sensorelementen,
- Figur 6: eine weitere Ausführungsform eines Hall-Sensors mit mehreren Hall-Sensorelementen,
- Figur 7: weitere Ausführungsformen eines Hall-Sensors mit mehreren Hall-Sensorelementen,
- Figur 8: eine schematische Darstellung einer weiteren Ausführungsform eines Hall-Sensors,
- Figur 9: eine schematische Darstellung einer weiteren Ausführungsform eines Hall-Sensors,
- Figur 10: weitere Ausführungsformen eines Hall-Sensors mit mehreren Hall-Sensorelementen,
- Figur 11: eine schematische Darstellung einer weiteren Ausführungsform eines Hall-Sensors,
- Figur 12: verschiedene schematische Darstellungen von Ausführungsformen eines Hall-Sensors mit mehreren Hall-Sensorelementen,
- Figur 13: eine schematische Darstellung einer weiteren Ausführungsform eines Hall-Sensors,
- Figur 14: weitere Ausführungsformen eines Hall-Sensors mit mehreren Hall-Sensorelementen,
- Figur 15: eine schematische Darstellung einer weiteren Ausführungsform eines Hall-Sensors,
- Figur 16: eine schematische Darstellung einer weiteren Ausführungsform eines Hall-Sensors,
- Figur 17: eine schematische Darstellung einer weiteren Ausführungsform eines Hall-Sensors,
- Figur 18: weitere Ausführungsformen eines Hall-Sensors mit mehreren Hall-Sensorelementen,
- Figur 19: eine schematische Darstellung einer weiteren Ausführungsform eines Hall-Sensors,
- Figur 20: eine schematische Darstellung einer Ausführungsform von Hall-Sensorelementen,
- Figur 21: eine weitere schematische Darstellung von Ausführungsformen von Hall-Sensorelementen,
- Figur 22: eine weitere Ausführungsform eines Hall-Sensors mit mehreren Hall-Sensorelementen,
- Figur 23: eine weitere Ausführungsform eines Hall-Sensors mit mehreren Hall-Sensorelementen,
- Figur 24: eine weitere Ausführungsform eines Hall-Sensors mit mehreren Hall-Sensorelementen,
- Figur 25: eine weitere Ausführungsform eines Hall-Sensors mit mehreren Hall-Sensorelementen,
- Figur 26: eine weitere schematische Darstellung von Ausführungsformen von Hall-Sensorelementen, und
- Figur 27: eine beispielhafte Darstellung eines Layouts einer Ausführungsform eines Hall-Sensors mit mehreren Hall-Sensorelementen.

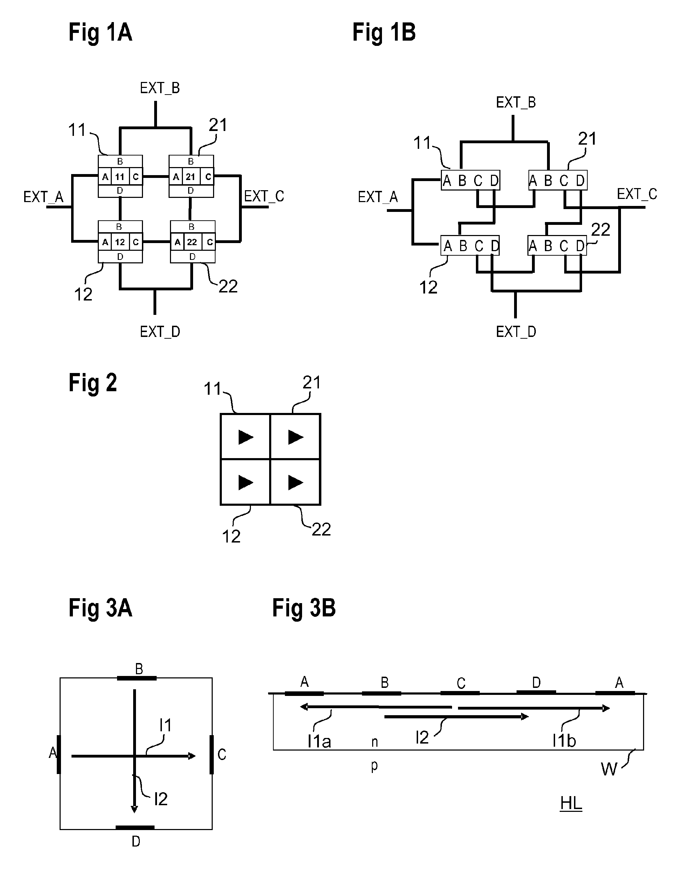

Figur 1 zeigt verschiedene Ausführungsformen eines Hall-Sensors mit mehreren Hall-Sensorelementen 11, 12, 21, 22, die miteinander verschaltet sind und derart gemeinsam einen größeren Hall-Sensor bilden. Hierbei ist in Figur 1A eine Ausführungsform mit lateralen Hall-Sensorelementen dargestellt, während in Figur 1B vertikale Hall-Sensorelemente verwendet werden. Die Hall-Sensorelemente 11, 12, 21, 22 weisen in den beiden Ausführungsformen in Figur 1A und Figur 1B jeweils vier Elementanschlüsse beziehungsweise Elementanschlüsse A, B, C, D auf, die zum Teil mit benachbarten Hall-Sensorelementen und zum Teil mit externen Anschlüssen beziehungsweise Sensoranschlüssen EXT_A, EXT_B, EXT_C, EXT_D verschaltet sind. Die Verschaltung verläuft bei beiden Ausführungsformen analog zueinander, sodass die folgende Beschreibung der Verschaltung sowohl für die Figur 1A als auch die Figur 1B gilt.

In dem Hall-Sensor sind die Elementanschlüsse A der Hall-Sensorelemente 11, 12 gemeinsam mit dem Sensoranschluss EXT_A verbunden. In ähnlicher Weise sind die Elementanschlüsse B der Elemente 11, 21 mit dem Sensoranschluss EXT_B, die Elementanschlüsse C der Elemente 21, 22 mit dem Sensoranschluss EXT_C und die Elementanschlüsse D der Elemente 12, 22 mit dem Sensoranschluss EXT_D verbunden. Zudem sind die Anschlüsse D des Elements 11 und B des Elements 12, die Anschlüsse C des Elements 11 und A des Elements 21, die Anschlüsse D des Elements 21 und B des Elements 22 sowie C des Elements 12 und A des Elements 22 miteinander verbunden.

Die Hall-Sensorelemente 11, 12, 21, 22 sind beispielsweise auf einer Fläche eines Halbleiterkörpers angeordnet, welche eine quadratische beziehungsweise rechteckige Form aufweist. Die in den Figuren 1A und 1B symbolisch dargestellten Ausführungsformen können als Draufsicht auf die Fläche beziehungsweise Oberfläche des Halbleiterkörpers verstanden werden. Die Hall-Sensorelemente können auch einzelne, diskrete Elemente sein.

In den dargestellten Ausführungsformen der Figur 1A und Figur 1B sind die einzelnen Hall-Sensorelemente 11, 12, 21, 22 mit gleicher Orientierung, insbesondere sowohl geometrischer als auch verschaltungstechnischer Orientierung, angeordnet, sodass sich im Betrieb des Hall-Sensors im Wesentlichen ähnliche Stromverteilungen in den einzelnen Hall-Sensorelementen ergeben. Insbesondere ergibt sich beispielsweise jeweils ein Signal beziehungsweise Signalfluss zwischen den Elementanschlüssen A und C, die mit den Sensoranschlüssen EXT_A, EXT_C verbunden sind, sowie zwischen den Elementanschlüssen B, D, die mit den Sensoranschlüssen EXT_B, EXT_D verbunden sind.

Diese Orientierung ist beispielsweise in Figur 2 schematisch dargestellt, wobei die Pfeilrichtung in den einzelnen Hall-Sensorelementen 11, 12, 21, 22 eine beispielhaft gewählte Orientierung, beispielsweise definiert durch eine Stromrichtung im Hall-Sensorelement, zwischen den Elementanschlüssen A, C darstellt.

In der Figur 3 sind beispielhaft Hall-Sensorelemente und ihre entsprechenden im Betrieb möglichen Stromflussrichtungen dargestellt. Hierbei zeigt Figur 3A eine Ausführungsform eines lateralen Hall-Sensorelements, bei dem in einer Betriebsphase, z.B. der spinning current Technik, ein Strom I1 vom Elementanschluss A zum Elementanschluss C fließt, während in einer anderen Betriebsphase ein Strom I2 vom Elementanschluss B zum Elementanschluss D fließt. Beispielsweise jeweils mittig sind an den Seiten des quadratisch dargestellten lateralen Hall-Sensorelements Anschlusskontakte für die Elementanschlüsse A, B, C, D vorgesehen. Mit einem solchen lateralen Hall-Sensorelement kann ein Magnetfeld senkrecht zu der quadratisch dargestellten Oberfläche des Elements gemessen werden.

In Figur 3B ist eine Ausführungsform eines vertikalen Hall-Sensorelements dargestellt, bei dem beispielsweise in einem p-dotierten Halbleiterkörper HL eine n-dotierte Wanne W vorgesehen ist. Auf der Oberfläche des Halbleiterkörpers HL beziehungsweise der Wanne W sind Kontaktflächen für die Elementanschlüsse A, B, C, D vorgesehen, wobei der Kontakt für den Elementanschluss A doppelt beziehungsweise symmetrisch ausgeführt ist.

In Analogie zu dem in Figur 3A dargestellten lateralen Hall-Sensorelement erfolgt bei dem vertikalen Hall-Sensorelement der Figur 3B in einer ersten Betriebsphase ein Stromfluss vom Elementanschluss C zu den Anschlusskontakten des Elementanschlusses A, gekennzeichnet durch die Strompfeile I1a, I1b. In einer zweiten Betriebsphase erfolgt in analoger Weise ein Stromfluss I2 vom Elementanschluss B zum Elementanschluss D. Mit dem in Figur 3B dargestellten Hall-Sensorelement kann ein Magnetfeld parallel zur Oberfläche des Halbleiterkörpers HL beziehungsweise der Wanne W gemessen werden. Insbesondere erfolgt eine Messung eines solchen Magnetfelds, das, bildlich ausgedrückt, senkrecht in die Darstellung der Figur 3B hineinläuft.

Die Empfindlichkeit und der Rest-Offset eines vertikalen Hall-Sensorelements hängen neben der räumlichen Entfernung der äußeren Anschlusskontakte auch von einer Wannentiefe der Wanne W ab. Um einen größeren vertikalen Hall-Sensor zu erhalten, wird daher bei herkömmlichen Hall-Sensoren die Wannentiefe vergrößert. Jedoch ist die Ausbildung einer großen Wannentiefe prozessbedingt begrenzt, sodass sich in herkömmlichen Hall-Sensoren keine beliebigen Größen erreichen lassen. Mit Verweis auf Figur 1B kann aber nach dem dort beschriebenen Prinzip durch die Verschaltung mehrerer kleinerer vertikaler Hall-Sensorelemente mit begrenzter Wannentiefe ein größerer Hall-Sensor gebildet werden, der bezüglich der Sensoranschlüsse EXT_A, EXT_B, EXT_C, EXT_D wie ein größerer Hall-Sensor wirkt. Durch die Verschaltung der Hall-Sensorelemente 11, 12, 21, 22 ergibt sich ein größerer Hall-Sensor mit verbesserter Genauigkeit beziehungsweise Empfindlichkeit. Zudem kann durch die Verschaltung der Hall-Sensorelemente eine Offset-Spannung beziehungsweise Restoffset-Spannung des Hall-Sensors verringert werden, insbesondere im Vergleich zu einem herkömmlichen Hall-Sensor ähnlicher Größe. Dies ist unter anderem dadurch bedingt, dass sich eine Hall-Spannung an den Sensoranschlüssen auf die einzelnen Hall-Sensorelemente verteilt und dadurch das elektrische Feld in den einzelnen Hall-Sensorelementen verringert. Durch das verringerte elektrische Feld ergibt sich ein verbessertes Verhalten bezüglich der Offset-Spannung.

Nach außen hin kann der Hall-Sensor wie ein herkömmlicher Hall-Sensor betrieben werden und insbesondere auch mit weiteren Hall-Sensoren verschaltet werden. Zudem ist es möglich, einen solchen Hall-Sensor zusätzlich mit bekannten Techniken, wie der Current Spinning Technik und Pairing, zu betreiben, um eine zusätzliche Reduktion von Offset-Spannungen beziehungsweise Restoffset-Spannungen zu erreichen.

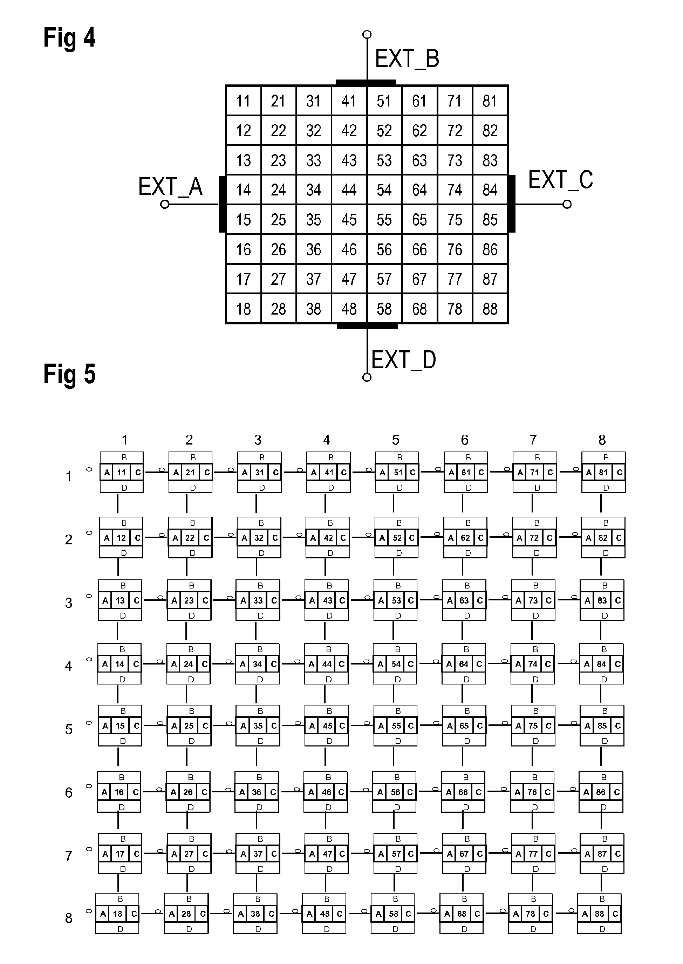

Figur 4 zeigt eine weitere Ausführungsform eines Hall-Sensors, welches auf dem in Figur 1 und Figur 2 beschriebenen Prinzip beruht. Hierbei weist der Hall-Sensor ein zweidimensionales 8 x 8 Gitter von Hall-Sensorelementen, also insgesamt 64 Hall-Sensorelemente, auf, die mit dem Bezugszeichen 11, 12, ..., bis 88 gekennzeichnet sind. Der Hall-Sensor weist wiederum vier Sensoranschlüsse EXT_A, EXT_B, EXT_C, EXT_D auf, die jeweils mit zwei der Hall-Sensorelemente verbunden sind. Insbesondere ist der Sensoranschluss EXT_A mit den Hall-Sensorelementen 14, 15, der Sensoranschluss EXT_B mit den Hall-Sensorelementen 41, 51, der Sensoranschluss EXT_C mit den Hall-Sensorelementen 84, 85 und der Sensoranschluss EXT_D mit den Hall-Sensorelementen 48, 58 verbunden. Beispielsweise sind sämtliche Hall-Sensorelemente 11, 12, ... 88 gleichartig ausgebildet und weisen auch eine gleiche Orientierung auf, beispielsweise entsprechend der in Figur 2 dargestellten Orientierung. Durch die größere Anzahl an Hall-Sensorelementen kann die Restoffset-Spannung weiter reduziert werden.

Die bei dem Hall-Sensor von Figur 4 verwendeten Hall-Sensorelemente können wiederum beispielsweise laterale Hall-Sensorelemente oder aber vertikale Hall-Sensorelemente sein.

Figur 5 zeigt beispielhaft eine Ausführungsform mit 64 Hall-Sensorelementen, die als laterale Hall-Sensorelemente ausgeführt sind. Ähnlich wie bei der Ausführungsform von Figur 1A sind sämtliche Hall-Sensorelemente mittig an den Seiten der quadratischen Grundform kontaktiert und unverdreht. Dies ist in der Zeichnung durch die Winkelangabe 0 (°) gekennzeichnet. Eine Kontaktierung mit den Sensoranschlüssen EXT_A, EXT_B, EXT_C, EXT_D erfolgt beispielsweise in Analogie zur Ausführungsform von Figur 4 an den Hall-Sensorelementen in der Zeile mit den Elementen 14, 15 bzw. der Spalte mit den Elementen 41,51.

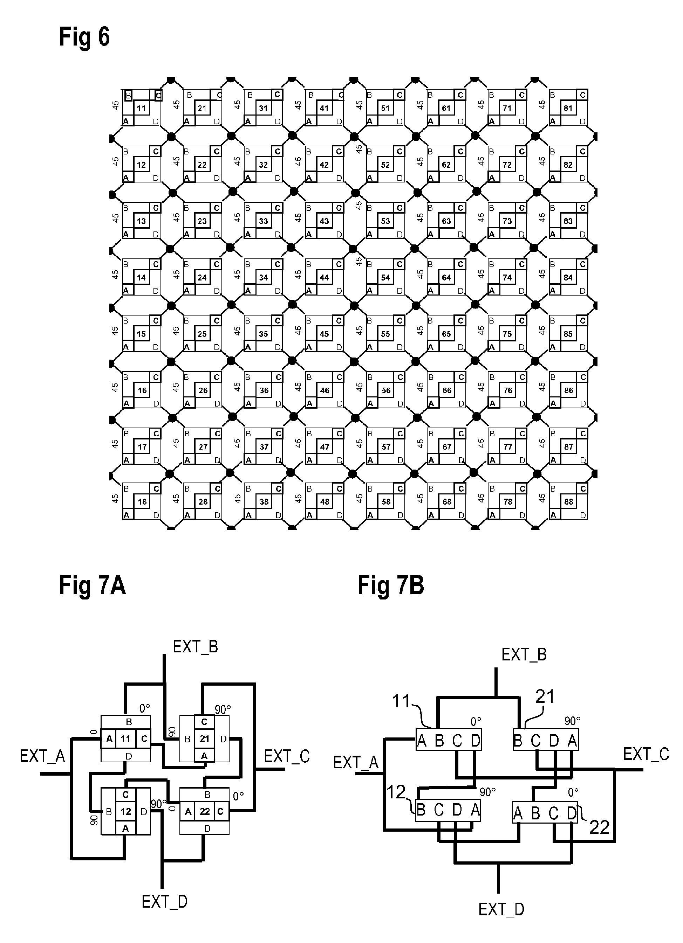

In Abweichung hiervon zeigt Figur 6 einen Hall-Sensor mit 64 Hall-Sensorelementen, welche an den Ecken der quadratischen Grundflächen kontaktiert sind. Hierbei ist zu erkennen, dass die innen liegenden Hall-Sensorelemente jeweils an den Ecken miteinander verbunden sind, sodass vier verschiedene Elementanschlüsse A, B, C, D von verschiedenen Hall-Sensorelementen jeweils verbunden sind. Durch die Kontaktierung an den Ecken ergibt sich ähnlich dem in Figur 3A beschriebenen Prinzip ein Stromfluss beziehungsweise Signalfluss diagonal durch das Hall-Sensorelement. Dies ist in der Zeichnung durch die Winkelangabe 45 (°) gekennzeichnet.

Die in Figur 6 dargestellte Kontaktierung der Hall-Sensorelemente lässt sich beispielsweise mit geringerem Aufwand auf einem Halbleiterkörper implementieren. Eine Kontaktierung mit den Sensoranschlüssen EXT_A, EXT_B, EXT_C, EXT_D erfolgt beispielsweise an den jeweils eckseitig anliegenden Elementanschlüssen der Hall-Sensorelemente 18, 11, 81, 88 für die Anschlüsse EXT_A, EXT_B, EXT_C, EXT_D. Alternativ kann eine Kontaktierung mit den Sensoranschlüssen EXT_A, EXT_B, EXT_C, EXT_D auch entsprechend der Verschaltung wie in Figur 4 gezeigt erfolgen, also an den Hall-Sensorelementen in der Zeile mit den Elementen 14, 15 bzw. der Spalte mit den Elementen 41, 51.

Während in den zuvor beschriebenen Ausführungsformen des Hall-Sensors die einzelnen Hall-Sensorelemente eine gleiche Ausrichtung beziehungsweise Orientierung aufweisen, zeigt Figur 7 weitere Ausführungsformen eines Hall-Sensors mit mehreren Hall-Sensorelementen, die in ihrer Orientierung verdreht zueinander verschaltet beziehungsweise angeordnet sind. Hierbei ist wiederum in Figur 7A eine Anordnung mit lateralen Hall-Sensorelementen 11, 12, 21, 22 und in Figur 7B eine Ausgestaltung eines Hall-Sensors mit vertikalen Hall-Sensorelementen 11, 12, 21, 22 dargestellt.

Im Vergleich zu den Ausführungsformen in Figur 1A und Figur 1B sind die Hall-Sensorelemente 12, 21 geometrisch für Figur 7a beziehungsweise elektrisch für Figur 7B um 90° verdreht, während die nominelle Verbindung der Elementanschlüsse A, B, C D untereinander und mit den Sensoranschlüssen gleich ist. Bei den lateralen Hall-Sensorelementen ergibt sich eine Orientierung des einzelnen Elements beispielsweise durch unterschiedliche Metallisierungsschichten, die verdreht zueinander hergestellt werden. Jedoch können laterale Hall-Sensorelemente auch symmetrisch, insbesondere rotationssymmetrisch bezüglich der Metallisierungsschichten aufgebaut sein. Durch die Drehung eines Teils der Hall-Sensorelemente ergibt sich im Betrieb des Hall-Sensors eine Kompensation der unterschiedlichen richtungsabhängigen Effekte, welche jeweils einen Teil zur Offset-Spannung beitragen, sodass der Offset insgesamt reduziert ist.

Während bei den lateralen Hall-Sensorelementen die Verdrehung tatsächlich durch eine geometrische Drehung des einzelnen Hall-Sensorelements erfolgt, wird dies bei der Ausführungsform mit vertikalen Hall-Sensorelementen in Figur 7B durch eine durchrotierte Kontaktierung der Halbleiterwanne W erreicht. Beispielsweise sind die Hall-Sensorelemente 11, 22 in Figur 7B unrotiert, mit einer Reihenfolge der Elementanschlüsse A-B-C-D, während bei den Elementen 12, 21 eine 90°-Drehung dadurch realisiert wird, dass als Kontaktreihenfolge B-C-D-A, also eine Durchrotierung der Anschlüsse erfolgt. Bezüglich der Reduktion des Offsets ergeben sich jedoch auch bei den vertikalen Hall-Sensorelementen beziehungsweise dem daraus gebildeten Hall-Sensor die gleichen Effekte der internen Offsetkompensation wie bei Figur 7A.

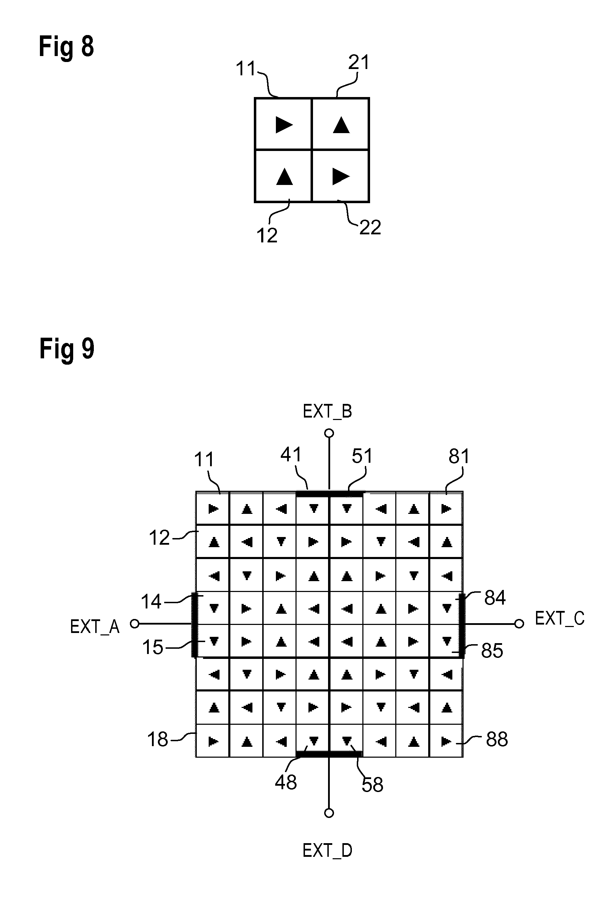

Das Prinzip der Verdrehung beziehungsweise der teilweise verdreht angeordneten Hall-Sensorelemente ist schematisch in Figur 8 dargestellt, wobei in Analogie zu Figur 2 die Pfeilrichtung eine entsprechende Orientierung des jeweiligen Hall-Sensorelements anzeigt.

Das Prinzip der Verdrehung lässt sich wiederum auch auf eine größere Anzahl von Hall-Sensorelementen ausdehnen, was beispielhaft für ein 8 x 8 Gitter in Figur 9 dargestellt ist. Die einzelnen Hall-Sensorelemente können hierbei wiederum sowohl als laterale Hall-Sensorelemente oder als vertikale Hall-Sensorelemente ausgeführt sein. Die Auswahl, welche Orientierung die einzelnen Hall-Sensorelemente jeweils aufweisen, kann beliebig, insbesondere auch anwendungsabhängig gewählt werden. Diesbezüglich ist die in Figur 9 dargestellte Auswahl der Orientierungen lediglich beispielhaft zu verstehen.

Beispielsweise wird eine Orientierung der einzelnen Elemente so gewählt, dass ein möglichst symmetrisch aufgebauter Hall-Sensor entsteht. Dazu werden insbesondere die einzelnen Hall-Sensorelemente so angeordnet beziehungsweise kontaktiert, dass von den Sensoranschlüssen her gesehen in allen sinnvollen Anschlusskombinationen eine gleiche beziehungsweise ähnliche Konfiguration vorliegt.

In den dargestellten Ausführungsformen sind die Hall-Sensorelemente quadratisch oder rechteckig dargestellt. Jedoch können die Hall-Sensorelemente bezüglich der äußeren Einhüllenden des Hall-Sensors auch kreuzförmig oder rund oder in beliebiger bekannter Form, beispielsweise Brückenform, Kleeblattform oder dergleichen gestaltet sein. Eine Kontaktierung der Elementanschlüsse erfolgt in Abhängigkeit der Form, beispielsweise bei einem kreuzförmigen Hall-Sensorelement an dessen Stirnflächen. In verschiedenen Ausführungsformen können die Elementanschlüsse der lateralen Hall-Sensorelemente an beliebigen Stellen des Umfangs beziehungsweise der Einhüllenden des Umfangs angeordnet sein, beispielsweise bei kreisrunden oder ovalen Hall-Sensorelementen. Bei eckigen Hall-Sensorelementen können die Elementanschlüsse dementsprechend an Seitenflächen in variabler Breite und/oder an den Ecken der Hall-Sensorelemente positioniert sein.

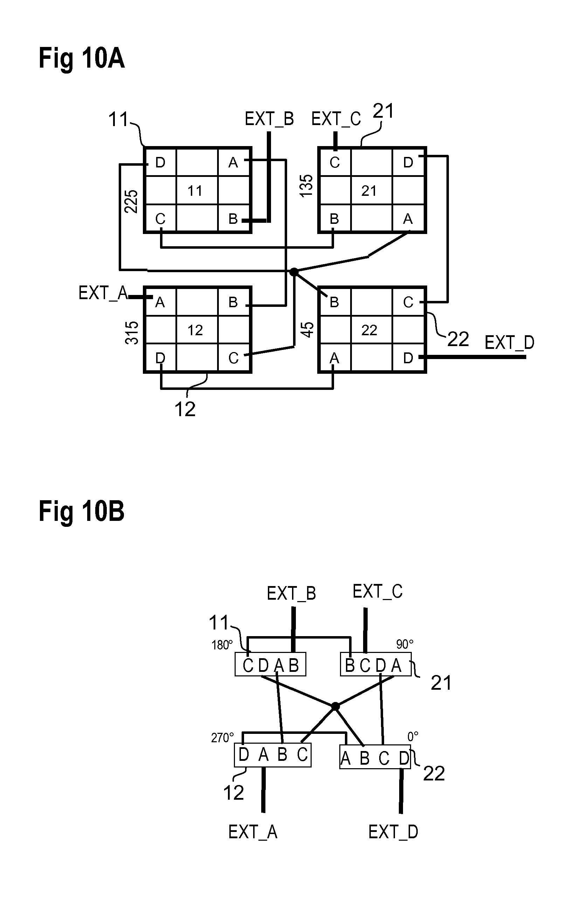

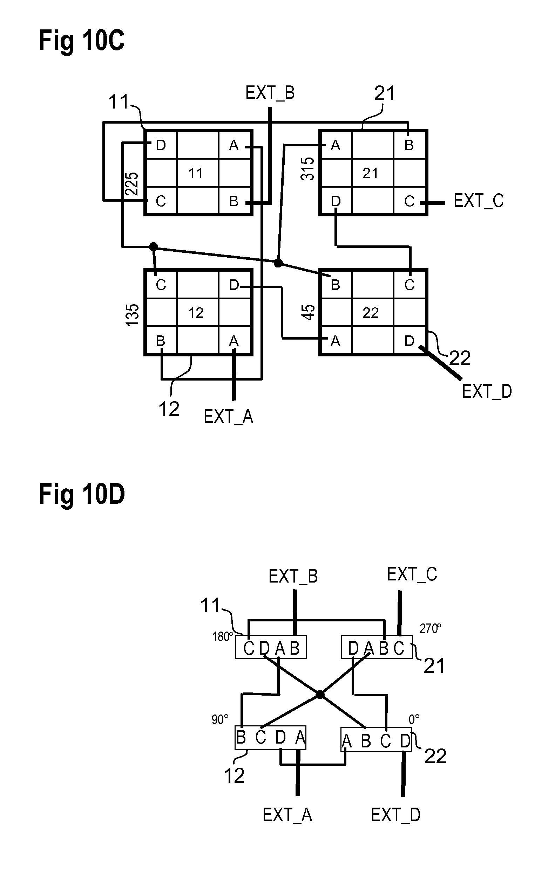

Figur 10 zeigt eine beispielhafte Ausführungsform eines Hall-Sensors mit vier Hall-Sensorelementen 11, 12, 21, 22, bei denen ein solches Prinzip realisiert ist. Hierbei sind in Figur 10A und Figur 10C Ausführungsformen mit lateralen Hall-Sensorelementen und in Figur 10B und Figur 10D Ausführungsformen mit vertikalen Hall-Sensorelementen dargestellt.

Bei den Ausführungsformen der Figur 10A und Figur 10C sind die Hall-Sensorelemente ähnlich wie bei der Ausführungsform von Figur 6 an festgelegten Ecken kontaktiert, um die jeweiligen Elementanschlüsse A, B, C, D bereitzustellen. Benachbarte Hall-Sensorelemente sind jeweils um 90° zueinander verdreht angeordnet. Der Sensoranschluss EXT_A ist mit dem Elementanschluss A des Elements 12 verbunden, der Sensoranschluss EXT_B mit dem Elementanschluss B des Elements 11, der Sensoranschluss EXT_C mit dem Elementanschluss C des Elements 21 und der Sensoranschluss EXT_D mit dem Elementanschluss D des Elements 22. Ferner sind alle vier Hall-Sensorelemente gemeinsam an einem ihrer Elementanschlüsse verbunden, nämlich am Anschluss A des Elements 21, am Anschluss B des Elements 22, am Anschluss C des Elements 12 und am Anschluss D des Elements 11. Weiterhin ist eine jeweilige Verbindung mit einem benachbart angeordneten Element in gleichartiger Weise vorgesehen. So ist der Anschluss B des Elements 12 mit dem Anschluss A des Elements 11, der Anschluss C des Elements 11 mit dem Anschluss B des Elements 21, der Anschluss D des Elements 21 mit dem Anschluss C des Elements 22 und der Anschluss A des Elements 22 mit dem Anschluss D des Elements 12 verbunden. Die Verdrehung der Elemente ist durch die Beträge der entsprechenden Winkelangaben 45, 135, 225, 315 (in Grad) gekennzeichnet. Die Drehrichtung der Verdrehung ist bei den Ausführungsformen der Figur 10A und Figur 10C unterschiedlich.

Durch die dargestellten und beschriebenen Verbindungen der einzelnen Hall-Sensorelemente ist in anschaulicher Weise eine Art Rotationssymmetrie beziehungsweise Punktsymmetrie des Hall-Sensors erreicht. Neben den zuvor besprochenen Effekten der Offsetkompensation wird durch die Symmetrie auch zusätzlich ein ausgeglichenes Betriebsverhalten des Hall-Sensors erreicht, bezogen auf verschiedene Kontaktierungsmöglichkeiten.

In Figur 10B und in Figur 10D ist ein vergleichbares Prinzip der Verschaltung für vertikale Hall-Sensorelemente dargestellt. Hierbei sind durch entsprechende Rotation der Anschlusskontakte der Elementanschlüsse A, B, C, D entsprechende Winkel von 0°, 90°, 180° und 270° hergestellt. Dazu weisen das jeweilige Hall-Sensorelement 11 eine Anschlussreihenfolge C-D-A-B, das Hall-Sensorelement 12 in Figur 10B bzw. das Element 21 in Figur 10D eine Anschlussreihenfolge D-A-B-C, das jeweilige Element 22 eine Anschlussfolge A-B-C-D und das Element 21 in Figur 10B bzw. das Element 12 in Figur 10D eine Anschlussreihenfolge B-C-D-A auf. Eine Verbindung der einzelnen Elementanschlüsse erfolgt nominell identisch wie bei der Ausführungsform mit lateralen Hall-Sensorelementen in Figur 10A beziehungsweise Figur 10C. Dementsprechend ergeben sich auch für den jeweiligen Hall-Sensor, der in Figur 10B und in Figur 10D dargestellt ist, ähnliche Effekte bezüglich der Symmetrie, der Offsetreduktion und des verbesserten Betriebsverhaltens.

Die Drehrichtung der Rotation der Elementanschlüsse ist bei den Ausführungsformen der Figur 10B und Figur 10D unterschiedlich.

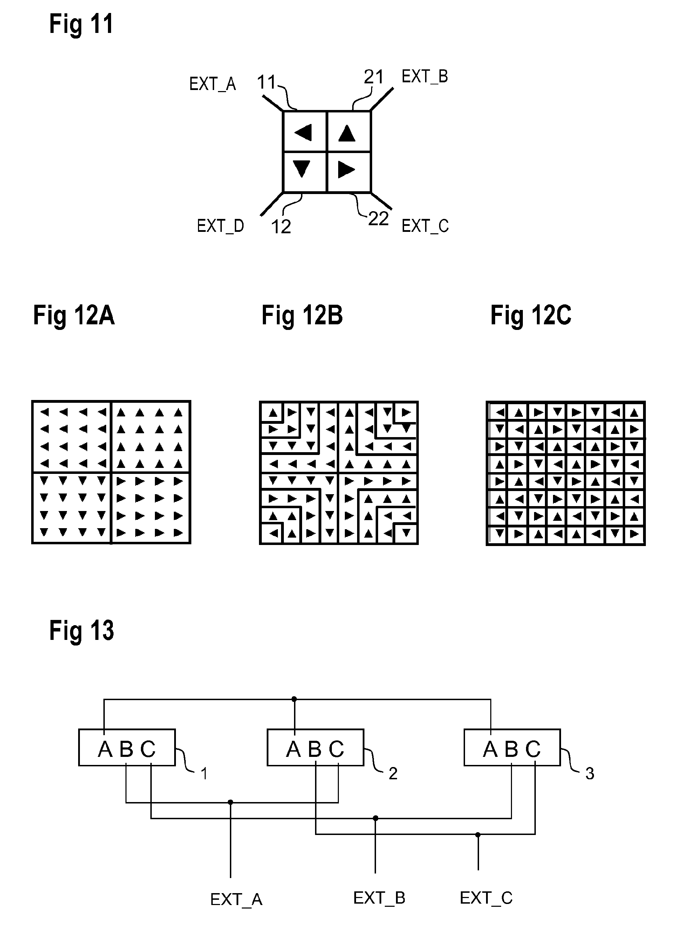

Das für die Figur 10 beschriebene Prinzip ist schematisch in Figur 11 dargestellt, bei der in Analogie zu Figur 2 und Figur 8 eine Darstellung der jeweiligen Orientierung der Hall-Sensorelemente mit Pfeilen gewählt ist. Hierbei lässt sich anschaulich erkennen, dass bei jeder Rotation um 90° wieder das gleiche Bild bezüglich Ausrichtung der einzelnen Hall-Sensorelemente und der Kontaktierung der Sensoranschlüsse gewährleistet ist.

In Figur 12 ist dieses Prinzip in verschiedenen Ausführungsformen für ein 8 x 8 Gitter mit 64 Hall-Sensorelementen dargestellt. Dabei sind die einzelnen Hall-Sensorelemente durch jeweilige Orientierungspfeile gekennzeichnet.

In Figur 12A ist hierbei jeder Quadrant mit gleich ausgerichteten Hall-Sensorelementen ausgebildet.

In der Ausführungsform in Figur 12B sind in jedem Quadranten L-förmige Anordnungen von Hall-Sensorelementen gleicher Orientierung vorgesehen, wobei jede L-Form bezüglich der benachbarten L-Form um 90° verdrehte Elemente aufweist. Der gesamte Hall-Sensor ist jedoch wiederum symmetrisch bezüglich jeder Drehung um 90°.

Figur 12C zeigt eine weitere Ausführungsform mit jeweils symmetrisch zueinander verdrehten Quadranten, bei denen jedes Hall-Sensorelement bezüglich seines Nachbarn um 90° verdreht ist.

Die verschiedenen Ausführungsformen, die in Figur 10, Figur 11 und Figur 12 dargestellt sind, weisen durch die Symmetrieeigenschaften eine gute Offsetkompensation und ein günstiges Betriebsverhalten auf. Die jeweils gewählten Orientierungen der einzelnen Hall-Sensorelemente sind nicht beschränkend aufzufassen, sodass die dargestellten Ausführungsformen nur beispielhaft für weitere mögliche Ausführungsformen sind.

Figur 13 zeigt eine weitere beispielhafte Ausführungsform eines Hall-Sensors, bei dem drei Hall-Sensorelemente 1, 2, 3 mit jeweils drei Elementanschlüssen A, B, C derart verschaltet sind, dass ein rotationssymmetrisch ähnliches oder identisches elektrisches Verhalten erreicht wird. Dazu sind die Elementanschlüsse A der drei Hall-Sensorelemente 1, 2, 3 gemeinsam miteinander verbunden. Zudem ist jeweils ein Elementanschluss B mit dem Elementanschluss C eines benachbarten Elements verbunden, zum Beispiel der Elementanschluss B des Elements 1 mit dem Elementanschluss des Elements 2, der Elementanschluss B des Elements 2 mit dem Elementanschluss C des Elements 3, und der Elementanschluss B des Elements 3 mit dem Elementanschluss C des Elements 1. An jeder dieser Verbindungen der Elementanschlüsse B, C ist ein jeweiliger Sensoranschluss EXT_A, EXT_B, EXT_C vorgesehen. Die Verschaltung entspricht einer Verdrehung der Hall-Sensorelemente um jeweils 120° zueinander.

Durch die dargestellte Verschaltung ergibt sich beispielsweise, dass ein elektrisches Verhalten zwischen den Anschlüssen EXT_A, EXT_B identisch oder im Wesentlichen identisch zu einem elektrischen Verhalten zwischen den Anschlüssen EXT_B, EXT_C beziehungsweise EXT_C und EXT_A ist. Dabei ist ein identisches Verhalten der Hall-Sensorelemente 1, 2, 3 angenommen. Zum Betrieb des Hall-Sensors werden jeweils zwei Sensoranschlüsse zur Versorgung des Hall-Sensors, beispielsweise mit einem BIAS-Strom, verwendet, während der dritte Sensoranschluss zum Abgreifen einer Hall-Spannung verwendet wird. Anstelle der dargestellten vertikalen Hall-Sensorelemente können auch laterale Hall-Sensorelemente mit drei Elementanschlüssen verwendet werden, die entsprechend verdreht sind.

Bei den zuvor beschriebenen Ausführungsbeispielen des Hall-Sensors sind die einzelnen Hall-Sensorelemente auf einer quadratischen oder rechteckförmigen Fläche auf dem Halbleiterkörper angeordnet. Eine solche Form ist günstig zu implementieren, ist jedoch nur als Beispiel für eine beliebige Form eines Hall-Sensors mit entsprechend verschalteten Hall-Sensorelementen zu verstehen. In anderen Ausführungsformen können auch beliebige andere Formen für die Fläche, auf der die Hall-Sensorelemente angeordnet sind, gewählt werden.

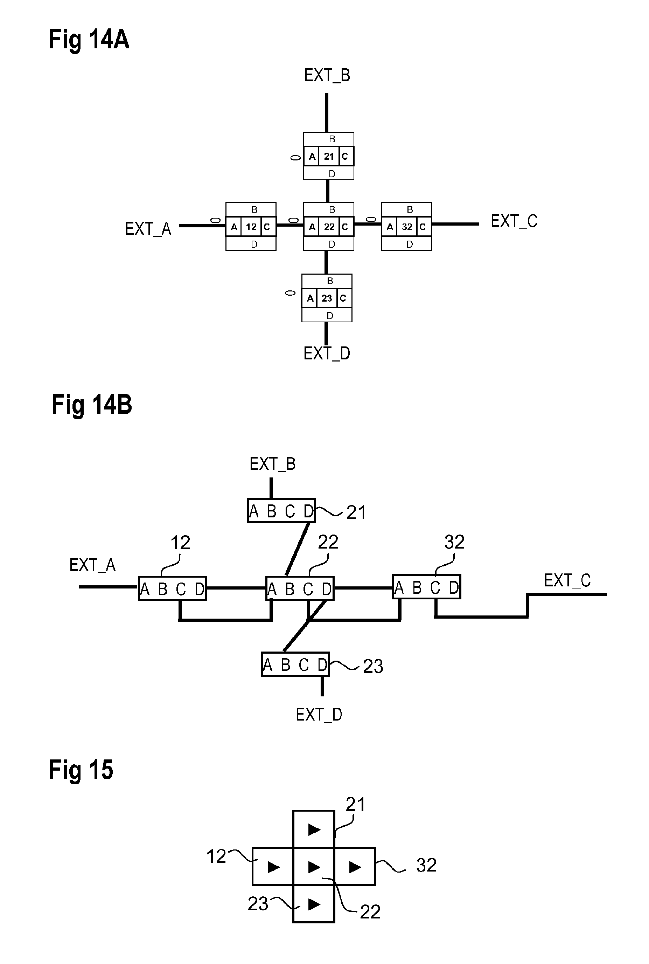

Figur 14 zeigt weitere Ausführungsformen eines Hall-Sensors mit mehreren Hall-Sensorelementen, bei denen eine Kreuzform für die Fläche gewählt ist. Hierbei ist in Figur 14A eine Ausführungsform mit lateralen Hall-Sensorelementen gezeigt, während Figur 14B eine Ausführungsform mit vertikalen Hall-Sensorelementen zeigt. Dabei sind jeweils fünf Hall-Sensorelemente 12, 21, 22, 23, 32 vorgesehen, die derart angeordnet sind, dass die Hall-Sensorelemente 12, 21, 23, 32 um das Hall-Sensorelement 22 herum angeordnet sind. Der Sensoranschluss EXT_A ist hierbei mit dem Elementanschluss A des Elements 12 verbunden, während der Sensoranschluss EXT_B mit dem Elementanschluss B des Elements 21, der Sensoranschluss EXT_C mit dem Elementanschluss C des Elements 32 und der Sensoranschluss EXT_D mit dem Elementanschluss D des Elements 23 verbunden sind. Die Elemente 12, 21, 22, 23, 32 sind unverdreht zueinander angeordnet. Dementsprechend sind der Elementanschluss A des Elements 22 mit dem Elementanschluss C des Elements 12, der Elementanschluss B des Elements 22 mit dem Elementanschluss D des Elements 21, der Elementanschluss C des Elements 22 mit dem Elementanschluss A des Elements 32 und der Elementanschluss D des Elements 22 mit dem Elementanschluss B des Elements 23 verbunden. Einzelne Elementanschlüsse bleiben frei, sind also weder mit anderen Elementanschlüssen noch mit Sensoranschlüssen verbunden.

Im Betrieb der in Figur 14A und Figur 14B dargestellten Hall-Sensoren teilt sich eine von den Sensoranschlüssen EXT_A, EXT_C beziehungsweise EXT_B, EXT_D anliegende Spannung auf die dazwischen liegenden Hall-Sensorelemente auf, was wiederum zu einem verringerten E-Feld im einzelnen Hall-Sensorelement führt. Dadurch kann der Restoffset beziehungsweise die Restoffset-Spannung gering gehalten werden.

Figur 15 zeigt eine schematische Darstellung der Anordnung der Hall-Sensorelemente entsprechend den Ausführungsformen der Figur 14A und Figur 14B. Die gleichsinnige Orientierung der Hall-Sensorelemente 12, 21, 22, 23, 32 ist wie in Figur 2 mit entsprechenden Pfeilen gekennzeichnet.

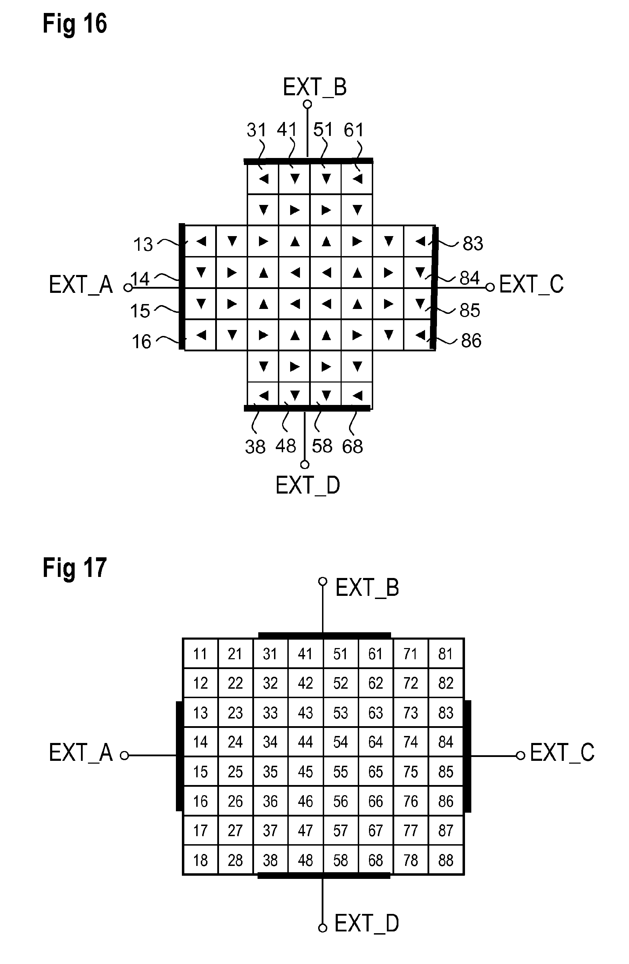

Die Kreuzform kann wiederum beliebig vergrößert werden, sodass der resultierende Hall-Sensor eine größere Anzahl von Hall-Sensorelementen umfasst. Dies ist beispielhaft durch die Ausführungsform in Figur 16 dargestellt. Hierbei umfasst der Hall-Sensor jeweils acht Hall-Sensorelemente in den Schenkelrichtungen. Die Schenkel des Kreuzes sind jeweils vier Hall-Sensorelemente breit. Die Hall-Sensorelemente, die am Rande eines Schenkels angeordnet sind, sind mit einem jeweiligen Sensoranschluss verbunden. Beispielsweise sind die Hall-Sensorelemente 13, 14, 15, 16 mit dem Sensoranschluss EXT_A, die Hall-Sensorelemente 31, 41, 51, 61 mit dem Sensoranschluss EXT_B, die Hall-Sensorelemente 83, 84, 85, 86 mit dem Sensoranschluss EXT_C und die Hall-Sensorelemente 38, 48, 58, 68 mit dem Sensoranschluss EXT_D verbunden. Die einzelnen Hall-Sensorelemente des Hall-Sensors sind mit unterschiedlichen Orientierungen angeordnet, die entsprechend der zuvor mehrmals verwendeten Kennzeichnung mit entsprechend ausgerichteten Pfeilen dargestellt ist.

Die Kreuzform des Hall-Sensors zeichnet sich neben den bereits beschriebenen Eigenschaften der geringen Offset-Spannung beziehungsweise geringen Restoffset-Spannung dadurch aus, dass im Betrieb geringe beziehungsweise vernachlässigbare Querströme von benachbarten Sensoranschlüssen auftreten. Beispielsweise ist im Betrieb ein Stromfluss zwischen den Sensoranschlüssen EXT_A und EXT_C beziehungsweise zwischen EXT_B und EXT_D gewünscht, während beispielsweise zwischen den Anschlüssen EXT_A und EXT_B kein Strom fließen soll. Dadurch, dass in den freien Ecken des Kreuzes keine Hall-Sensorelemente vorhanden sind, also beispielsweise im Vergleich zur Figur 4 die Elemente 11, 12, 21, 22 fehlen, ist dort kein Stromfluss vorhanden. Dies verbessert unter anderem die Empfindlichkeit des Hall-Sensors.

Figur 17 zeigt wiederum einen quadratischen beziehungsweise rechteckförmigen Hall-Sensor mit einem 8 x 8 Gitter, ähnlich wie in Figur 4 dargestellt. Während in Figur 4 jeweils die zwei mittleren Hall-Sensorelemente einer jeden Seite mit einem der Sensoranschlüsse EXT_A, EXT_B, EXT_C, EXT_D verbunden sind, ist die Anzahl der verbundenen Hall-Sensorelemente bei der Ausführungsform der Figur 17 auf vier erhöht. Dementsprechend sind der Sensoranschluss EXT_A mit den Hall-Sensorelementen 13, 14, 15, 16, der Sensoranschluss EXT_B mit den Hall-Sensorelementen 31, 41, 51, 61, der Sensoranschluss EXT_C mit den Hall-Sensorelementen 83, 84, 85, 86 und der Sensoranschluss EXT_D mit den Hall-Sensorelementen 38, 48, 58, 68 verbunden.

Durch die höhere Anzahl der Hall-Sensorelemente, die mit einem Sensoranschluss verbunden sind, ergibt sich ein niedrigerer Eingangswiderstand beim Betrieb des Hall-Sensors zwischen den entsprechenden Sensoranschlüssen. Dieser Eingangswiderstand hat beispielsweise Einfluss auf das thermische Rauschen, welches die Genauigkeit des Hall-Sensors beeinflusst. Allgemein ergibt sich, dass der Eingangswiderstand des Hall-Sensors mit steigender Zahl extern verbundener Hall-Sensorelemente sinkt. Zudem gilt, dass die Genauigkeit des Hall-Sensors mit sinkendem Eingangswiderstand steigt. Jedoch ergibt sich bei höherem Eingangswiderstand ein höherer Betriebsstrom, um eine gewünschte Größenordnung der am Hall-Sensor anliegenden Hall-Spannung zu erreichen. Dadurch bewirkt ein niedrigerer Eingangswiderstand in der Regel einen höheren Energieverbrauch beim Betrieb des Hall-Sensors. Die Wahl des gewünschten Eingangswiderstands beziehungsweise der gewünschten Anzahl von extern kontaktierten Hall-Sensorelementen kann daher anwendungsspezifisch variiert werden.

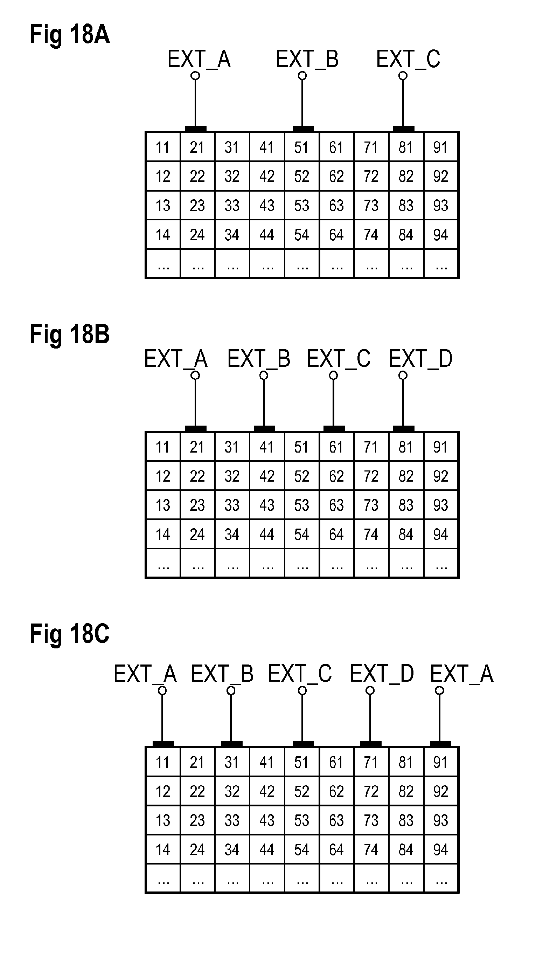

Figur 18 zeigt weitere Ausführungsformen eines Hall-Sensors, bei dem die Sensoranschlüsse alle an einer Seite der verschalteten Hall-Sensorelemente 11, ..., 94 angeordnet sind. In den Abbildungen der Figur 18 sind beispielhaft lediglich vier beziehungsweise fünf Zeilen einer Verschaltungsmatrix von Hall-Sensorelementen dargestellt, wobei die Zahl der Zeilen auch größer beziehungsweise unterschiedlich gewählt werden kann, um beispielsweise eine quadratische Schaltungsmatrix von Hall-Sensorelementen zu erhalten.

In Figur 18A sind drei Sensoranschlüsse EXT_A, EXT_B, EXT_C vorgesehen, wobei der Sensoranschluss EXT_A mit dem Hall-Sensorelement 21, der Sensoranschluss EXT_B mit dem Hall-Sensorelement 51 und der Sensoranschluss EXT_C mit dem Hall-Sensorelement 81 verbunden ist. Im Betrieb eines solchen Hall-Sensors, wie er in Figur 18A dargestellt ist, erfolgt eine Messung beispielsweise durch Anlegen eines Versorgungssignals an zwei der Sensoranschlüsse, während am dritten Sensoranschluss eine Hall-Spannung gegenüber einem Bezugspotential gemessen wird.

In Figur 18B ist eine Ausführungsform eines Hall-Sensors dargestellt, bei dem vier Sensoranschlüsse EXT_A, EXT_B, EXT_C, EXT_D vorgesehen sind, entsprechend den zuvor beschriebenen Ausführungsbeispielen. Hierbei ist der Sensoranschluss EXT_A mit dem Hall-Sensorelement 21, der Sensoranschluss EXT_B mit dem Hall-Sensorelement 41, der Sensoranschluss EXT_C mit dem Hall-Sensorelement 61 und der Sensoranschluss EXT_D mit dem Hall-Sensorelement 81 verbunden.

In Figur 18C ist eine weitere Ausführungsform eines Hall-Sensors dargestellt, bei dem fünf Sensoranschlüsse vorgesehen sind. Hierbei ist in Analogie zu der Ausführungsform des vertikalen Hall-Sensorelements in Figur 3B ein äußerer Sensoranschluss EXT_A doppelt ausgeführt. Dementsprechend ist in dieser Ausführungsform der Sensoranschluss EXT_A mit den Hall-Sensorelementen 11 und 91, der Sensoranschluss EXT_B mit dem Hall-Sensorelement 31, der Sensoranschluss EXT_C mit dem Hall-Sensorelement 51 und der Sensoranschluss EXT_D mit dem Hall-Sensorelement 71 verbunden.

Unabhängig von der Zahl der Sensoranschlüsse, die bei den Ausführungsformen der Figur 18 verwendet werden, können jeweils Hall-Sensorelemente mit beispielsweise vier oder fünf Elementanschlüssen miteinander verschaltet werden. Nach außen hin, also zu den Sensoranschlüssen, verhält sich der Hall-Sensor entsprechend der gewählten Anzahl von Sensoranschlüssen, die vorgesehen sind.

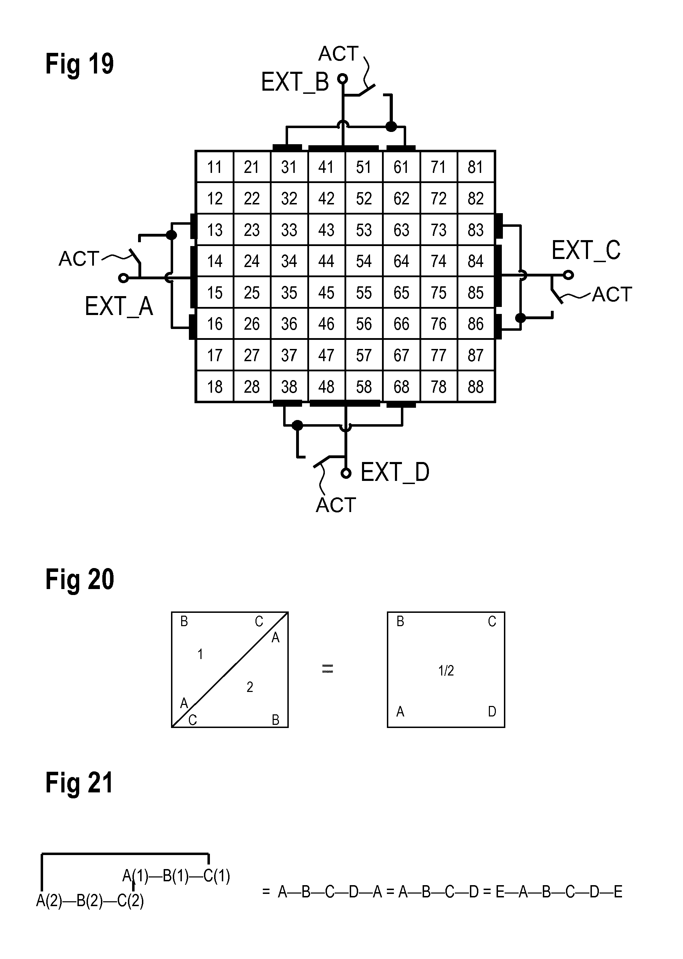

Figur 19 zeigt eine weitere Ausführungsform eines Hall-Sensors, die auf der Ausführungsform der Figur 4 beziehungsweise der Figur 17 basiert. Hierbei sind wie bei der Figur 4 der Sensoranschluss EXT_A mit den Hall-Sensorelementen 14, 15, der Sensoranschluss EXT_B mit den Hall-Sensorelementen 41, 51, der Sensoranschluss EXT_C mit den Hall-Sensorelementen 84, 85 und der Sensoranschluss EXT_D mit den Hall-Sensorelementen 48, 58 fest verbunden. Zudem ist eine schaltbare Verbindung der Sensoranschlüsse EXT_A, EXT_B, EXT_C, EXT_D zu den jeweils benachbart zu den fest verbundenen Hall-Sensorelementen liegenden Elementen vorgesehen. Dementsprechend sind der Sensoranschluss EXT_A mit den Hall-Sensorelementen 13, 16, der Sensoranschluss EXT_B mit den Hall-Sensorelementen 31, 61, der Sensoranschluss EXT_C mit den Hall-Sensorelementen 83, 86 und der Sensoranschluss EXT_D mit den Hall-Sensorelementen 38, 68 über einen jeweiligen Schalter, der über ein Steuersignal ACT aktiviert werden kann, schaltbar verbunden.

Bei einer derartigen Verschaltung kann der Hall-Sensor beispielsweise in zwei Betriebsarten betrieben werden, nämlich einem Ruhebetrieb oder Standby-Betrieb und einem aktiven Betrieb oder Normalbetrieb. Im Ruhebetrieb wird beispielsweise eine geringe Genauigkeit von dem Hall-Sensor erwartet, sodass die durch das Steuersignal ACT gesteuerten Schalter offen gesteuert werden. Dadurch ergibt sich für den Hall-Sensor ein höherer Eingangswiderstand, welcher einen niedrigen Strom und damit einen niedrigeren Energieverbrauch bewirkt. Der Hall-Sensor ist dennoch funktionsfähig und kann ein Magnetfeldsignal messen, wenn auch mit geringerer Genauigkeit beziehungsweise Empfindlichkeit. Der Hall-Sensor ist dementsprechend in einem hochohmigen Betrieb.

Wenn eine höhere Genauigkeit gewünscht ist, kann in den aktiven Betrieb umgeschaltet werden, in dem die Schalter durch ein entsprechendes Steuersignal ACT geschlossen werden. Dadurch wird der Hall-Sensor in einem niederohmigen Modus betrieben. In dem aktiven Betrieb kann somit eine genauere beziehungsweise empfindlichere Messung mit dem Hall-Sensor durchgeführt werden. Das Umschalten zwischen dem Ruhebetrieb und dem aktiven Betrieb kann beispielsweise durch eine externe Steuerung vorgenommen werden oder aber auf der Basis eines Messsignals des Hall-Sensors im Ruhebetrieb, beispielsweise wenn ein Grenzwert bei der Messung mit dem Hall-Sensor überschritten wird.

Je nach Anzahl der verwendeten Hall-Sensorelemente kann in dem aktiven Betrieb auch eine größere Anzahl von zusätzlichen Hall-Sensorelementen mit den Sensoranschlüssen verbunden werden. Ferner ist in Figur 19 beispielhaft eine quadratische beziehungsweise rechteckige Form gewählt, die in anderen Ausführungsformen auch durch andere Flächenformen ersetzt werden kann, beispielsweise durch die in Figur 16 dargestellte Kreuzform.

Bei der Wahl der zu kontaktierenden Hall-Sensorelemente ist zu beachten, dass verbundene Hall-Sensorelemente über die Ecken hinweg das Auftreten von unerwünschten Kurzschlussströmen zwischen benachbarten Sensoranschlüssen begünstigen können.

Weitere Abwandlungen der bisherigen Ausführungsformen können durch Wahl einer anderen Form beziehungsweise einer anderen Zahl von Elementanschlüssen der verwendeten Hall-Sensorelemente erreicht werden. Bei den bisher dargestellten Ausführungsformen wurden quadratische beziehungsweise rechteckige laterale Hall-Sensorelemente mit drei oder vier Elementanschlüssen oder entsprechende vertikale Hall-Sensorelemente mit vier Kontakten verwendet. Bezüglich der vertikalen Hall-Sensorelemente kann, wie in Figur 3B dargestellt, auch ein Element mit fünf Kontakten eingesetzt werden, bei denen der Elementanschluss A auf zwei Kontakte aufgeteilt ist. Weiterhin können auch vertikale Hall-Sensorelemente mit vier Anschlusskontakten und zwei äußeren, kurzgeschlossenen Kontakten verwendet werden.

In verschiedenen Ausgestaltungen der Ausführungsformen, die in Figur 2, Figur 4, Figur 8, Figur 9, Figur 12, Figur 17, Figur 18 und Figur 19 gezeigt sind, kann eine Kontaktierung zwischen den Hall-Sensorelementen, insbesondere bei der Ausgestaltung als laterale Hall-Sensorelemente, in den Ecken und/oder an den Seitenflächen erfolgen. Eine Verschaltung erfolgt also beispielsweise gemäß Figur 5 oder Figur 6.

In Figur 20 ist beispielhaft dargestellt, dass insbesondere bei einem lateralen Hall-Sensorelement auch eine Dreiecksform für ein einzelnes Element gewählt werden kann. Hierbei sind zwei dreiecksförmige Hall-Sensorelemente 1, 2 mit jeweiligen Elementanschlüssen A, B, C dargestellt. Anstelle der Dreiecksform kann auch eine andere Form gewählt werden, wobei das Hall-Sensorelement jeweils drei Elementanschlüsse aufweist. Hierbei ist jeweils der Elementanschluss A eines Elements mit dem Elementanschluss C des anderen Elements elektrisch verbunden. Praktisch verhalten sich zwei derartig zusammengeschaltete dreiecksförmige Hall-Sensorelemente 1, 2 mit jeweils drei Elementanschlüssen A, B, C wie ein rechteckiges beziehungsweise quadratisches laterales Hall-Sensorelement mit vier Elementanschlüssen A, B, C, D, was in Figur 20 durch das Gleichheitszeichen ausgedrückt ist.

Das in der linken Hälfte der Figur 20 dargestellte Verschaltungskonzept der zwei Hall-Sensorelemente 1, 2 lässt sich auch auf vertikale Hall-Sensorelemente übertragen. Dies ist beispielhaft in Figur 21 mit zwei vertikalen Hall-Sensorelementen dargestellt, die jeweils drei Elementanschlüsse A, B, C aufweisen. Die Elementanschlüsse A(1), B(1), C(1) des ersten Hall-Sensorelements 1 sind in entsprechender Weise mit den Elementanschlüssen A(2), B(2), C(2) des zweiten Hall-Sensorelements 2 verschaltet, wobei insbesondere ein elektrischer Kontakt zwischen den Elementanschlüssen A(2) und C(1) beziehungsweise A(1) und C(2) hergestellt ist. Dies entspricht praktisch wiederum einem herkömmlichen vertikalen Hall-Sensorelement mit vier Anschlüssen A-B-C-D oder fünf Anschlüssen A-B-C-D-A oder vier Anschlüssen mit außenseitigem Kurzschluss E-A-B-C-D-E, was wiederum durch die Gleichheitszeichen in Figur 21 ausgedrückt ist.

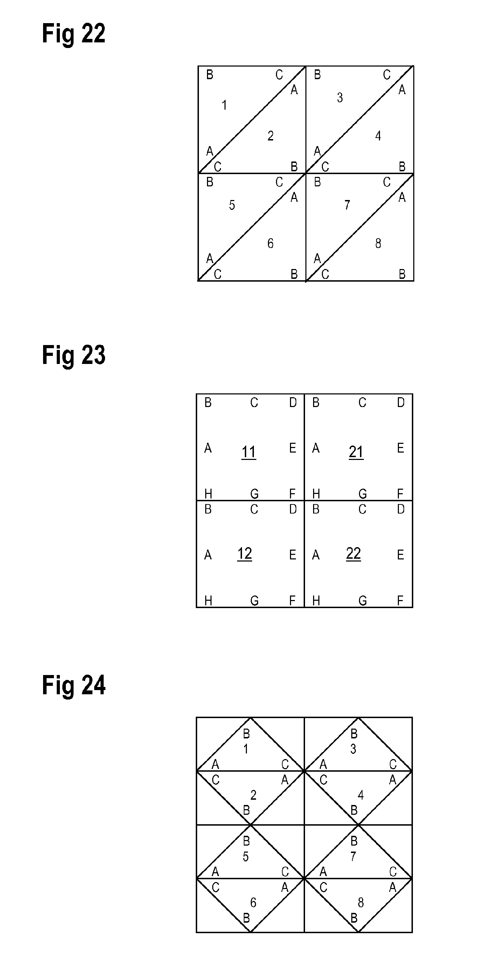

Figur 22 zeigt eine weitere Ausführungsform eines Hall-Sensors mit mehreren Hall-Sensorelementen, die hierbei dreiecksförmig sind. Insbesondere umfasst der Hall-Sensor acht Hall-Sensorelemente 1, 2, ..., 8 mit jeweils drei Elementanschlüssen A, B, C. Elementanschlüsse der einzelnen Hall-Sensorelemente, die unmittelbar aneinander angrenzen, sind elektrisch miteinander verbunden. Beispielsweise ist der Elementanschluss A des Elements 1 mit dem Elementanschluss C des Elements 2 und dem Elementanschluss B des Elements 5 verbunden. Weiterhin sind die mittig liegenden Anschlüsse der Elemente 2, 3, 4, 5, 6, 7 elektrisch kontaktiert. Sensoranschlüsse des Hall-Sensors können beispielsweise an den Ecken des resultierenden Quadrats beziehungsweise Rechtecks vorgesehen werden. Alternativ können die Sensoranschlüsse auch mittig an den Seiten des Quadrats beziehungsweise Rechtecks gewählt werden. Weiterhin können sowohl die mittig an den Seiten liegenden als auch die an den Ecken liegenden Anschlüsse als Sensoranschlüsse des Hall-Sensors verwendet werden, sodass ein Hall-Sensor mit acht Sensoranschlüssen resultiert.

Figur 23 zeigt eine weitere Ausführungsform eines Hall-Sensors mit mehreren Hall-Sensorelementen 11, 12, 21, 22, die in dieser Ausführungsform jeweils acht Elementanschlüsse A, B, C, D, E, F, G, H aufweisen. Jedes der Hall-Sensorelemente 11, 12, 21, 22 kann ein vollständiger quadratischer oder rechteckiger lateraler Hall-Sensor mit acht Elementanschlüssen sein, oder aber beispielsweise durch einen Hall-Sensor mit acht Anschlüssen, wie er in Figur 22 dargestellt ist, gebildet sein. Die benachbart zueinander angeordneten Elementanschlüsse der einzelnen Hall-Sensorelemente sind wiederum elektrisch miteinander verbunden. Beispielsweise sind also die Elementanschlüsse H beziehungsweise G des Elements 11 mit den Elementanschlüssen B beziehungsweise C des Elements 12 verbunden. Ferner ist der Anschluss F des Elements 11 mit dem Anschluss H des Elements 21, dem Anschluss B des Elements 22 und dem Anschluss D des Elements 12 verbunden. Weitere Verbindungen ergeben sich unmittelbar aus der Zeichnung und sind hier nicht im Einzelnen erläutert, um Wiederholungen zu vermeiden.

Der resultierende Hall-Sensor gemäß Figur 23 kann wiederum als Hall-Sensor mit vier Sensoranschlüssen verwendet werden, die beispielsweise an den jeweiligen Ecken der quadratisch beziehungsweise rechteckigen Form oder an den Seitenmitten dieser Form kontaktiert sind. Ferner kann in Analogie zu der Ausführungsform in Figur 22 auch ein Hall-Sensor mit acht Sensoranschlüssen gebildet werden, der sowohl an den Ecken als auch an den Seitenmitten kontaktiert ist.

In Figur 22 und Figur 23 ist die gesamte quadratische beziehungsweise rechteckige Fläche des Hall-Sensors mit den einzelnen Hall-Sensorelementen aufgefüllt. Jedoch können auch bestimmte Bereiche einer quadratischen oder rechteckigen Fläche eines Hall-Sensors frei bleiben. Figur 24 zeigt eine Ausführungsform eines grundsätzlich quadratischen beziehungsweise rechtecksförmigen Hall-Sensors mit acht dreiecksförmigen Hall-Sensorelementen 1, 2, ..., 8, die nur die Hälfte der verfügbaren Fläche bedecken. Hierbei ist in jedem Quadranten des Hall-Sensors eine auf der Spitze stehende Raute vorgesehen, die durch jeweils zwei dreieckige Hall-Sensorelemente gebildet ist. Wie bei den vorigen Ausführungsformen in Figur 22 oder Figur 23 sind aneinander angrenzende beziehungsweise benachbart liegende Elementanschlüsse der einzelnen Hall-Sensorelemente elektrisch miteinander verbunden, beispielsweise die Elementanschlüsse B der Elemente 2 und 5 beziehungsweise 4 und 7 oder die Anschlüsse A mit den Anschlüssen C des jeweils benachbart liegenden Hall-Sensorelements.

Die dargestellte Ausführungsform resultiert in einem Hall-Sensor mit vier Sensoranschlüssen, die durch die Elementanschlüsse B der Elemente 1 und 3, die außen liegenden Elementanschlüsse A, C der Elemente 3, 4, 7, 8, die Elementanschlüsse B der Elemente 6, 8 sowie die außen liegenden Elementanschlüsse A, C der Elemente 1, 2, 5, 6 gebildet sind.

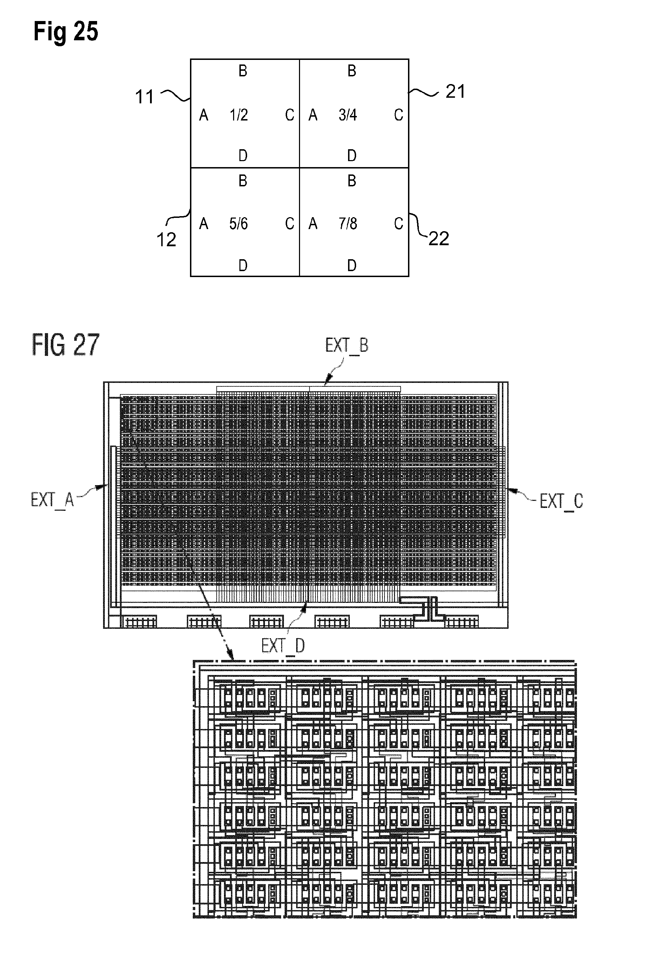

Praktisch entspricht dies im Wesentlichen einem Hall-Sensor mit vier rechteckigen beziehungsweise quadratischen Hall-Sensorelementen 11, 12, 21, 22, wie er in Figur 25 dargestellt ist. So ergibt sich beispielsweise das Hall-Sensorelement 11 aus einer Kombination der dreieckigen Elemente 1 und 2, das Hall-Sensorelement 21 aus einer Kombination der Elemente 3 und 4, etc. Schaltungstechnisch lässt sich die in Figur 25 dargestellte Ausführungsform somit auf die in Figur 1 ausgeführte Variante des Hall-Sensors zurückführen, wobei jedes der quadratischen oder rechteckförmigen Hall-Sensorelemente aus zwei dreiecksförmigen Hall-Sensorelementen entsprechend der Anordnung der Figur 24 zusammengesetzt ist.

Auch wenn in den Figuren 22 bis 25 laterale Hall-Sensorelemente beispielhaft dargestellt sind, kann eine entsprechende Verschaltung auch mit vertikalen Hall-Sensorelementen erfolgen. Dies kann auch unter Berücksichtigung der in Figur 21 dargestellten Beziehungen geschehen. Die in den Figuren 22 bis 25 dargestellten Ausführungsformen stellen Beispiele einer gitterartigen Verschaltung von Hall-Sensorelementen dar.

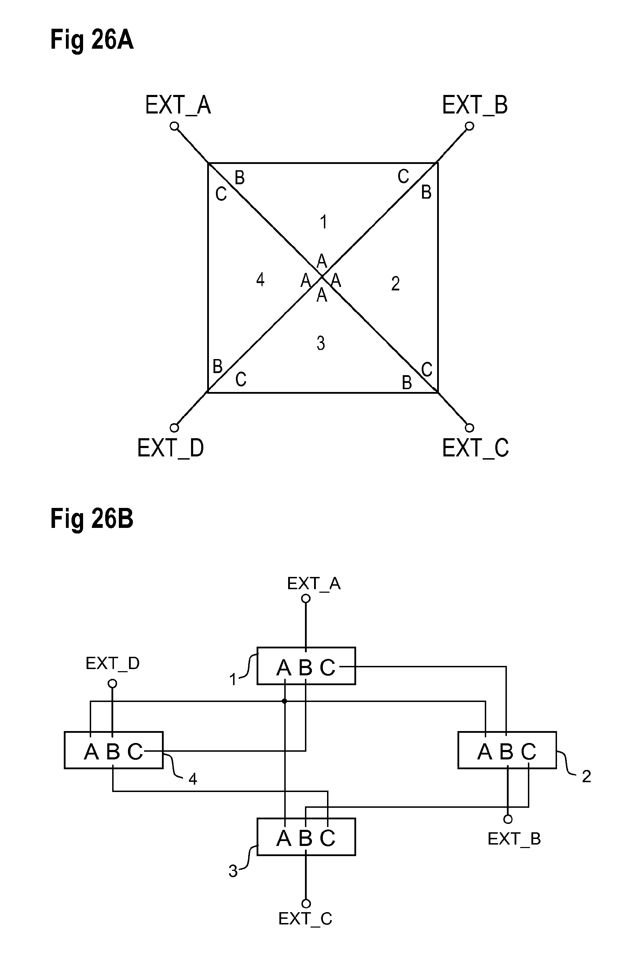

Figur 26 zeigt eine weitere beispielhafte Ausführungsform eines Hall-Sensors, bei dem Hall-Sensorelemente 1, 2, 3, 4 mit jeweils drei Elementanschlüssen A, B, C verschaltet sind. Hierbei ist in Figur 26A eine Ausführungsform mit beispielhaft dreiecksförmig dargestellten lateralen Hall-Sensorelementen abgebildet, während in Figur 26B eine entsprechende Ausführungsform mit vertikalen Hall-Sensorelementen gezeigt ist.

Dabei sind jeweils die Elementanschlüsse A der Hall-Sensorelemente 1, 2, 3, 4 zusammengeschaltet beziehungsweise miteinander verbunden. In Figur 26A ist dies beispielsweise durch die Aufteilung einer rechteckigen beziehungsweise quadratischen Fläche in vier spitz aufeinander stehenden Dreiecksflächen umgesetzt. Ferner sind jeweils die Elementanschlüsse B eines Hall-Sensorelements mit einem Elementanschluss C eines benachbarten Hall-Sensorelements verbunden, was in Figur 26A beispielsweise durch die benachbarte Anordnung der Hall-Sensorelemente beziehungsweise die gegenüberliegenden Elementanschlüsse B, C dargestellt ist. Die gemeinsamen Verbindungen der Elementanschlüsse B, C bilden jeweils einen der vier Sensoranschlüsse EXT_A, EXT_B, EXT_C, EXT_D. Die Verschaltung entspricht einer Verdrehung der Hall-Sensorelemente um jeweils 90° zueinander.

Ähnlich wie bei den in Figur 10 bis Figur 13 dargestellten Ausführungsformen ergibt sich durch die in Figur 26 gezeigte Verschaltung der Hall-Sensorelemente eine Art Rotationssymmetrie, sodass beispielsweise ein elektrisches Verhalten zwischen den Sensoranschlüssen EXT_A und EXT_C identisch oder im Wesentlichen identisch zu einem elektrischen Verhalten zwischen den Sensoranschlüssen EXT_B und EXT_D ist. Die in Figur 26 dargestellten Ausführungsformen lassen sich auch mit einer größeren Anzahl an Hall-Sensorelementen realisieren. So ist die in Figur 26 dargestellte Variante mit vier Hall-Sensorelementen lediglich der besseren Übersicht halber gewählt.

Neben den dargestellten Formen können auch weitere Formen für die Fläche des Hall-Sensors gewählt werden. Zudem kann eine Aufteilung der Fläche in die einzelnen Hall-Sensorelemente auch durch weitere Formen erfolgen. Wenn beispielsweise gleichseitige Dreiecke für die Aufteilung der Fläche eines lateralen Hall-Sensors gewählt werden, können sechs solcher Dreiecke zu einem Hall-Sensor mit sechs Sensoranschlüssen kombiniert werden. Ein solcher lateraler Hall-Sensor mit sechs Kontakten entspricht beispielsweise auch einem vertikalen Hall-Sensor mit sechs Kontakten. Durch die angegebene Kombination der jeweils sechs gleichseitigen Dreiecke als Hall-Sensorelemente kann die Fläche des Hall-Sensors in eine honigwabenartige Struktur mit mehreren Hexagonen aufgeteilt werden.

In den dargestellten Ausführungsformen sind ferner die Hall-Sensorelemente, insbesondere die lateralen Hall-Sensorelemente, quadratisch, rechteckig oder kreuzförmig dargestellt. Jedoch können die Hall-Sensorelemente auch vieleckig oder rund oder in beliebiger bekannter Form, beispielsweise Brückenform, Kleeblattform oder dergleichen gestaltet sein. Dahingehend sind deshalb die dargestellten Ausführungsformen lediglich beispielhaft für verschiedene Variationsmöglichkeiten zu sehen.

Bei den zuvor beschriebenen Ausführungsformen des Hall-Sensors sind die internen Verbindungen zwischen den Elementanschlüssen der einzelnen Hall-Sensorelemente als feste Verbindungen, beispielsweise durch direkten elektrischen Kontakt, realisiert. Jedoch ist es in weiteren Abwandlungen möglich, die internen Verbindungen zwischen den Elementanschlüssen der Hall-Sensorelemente geschaltet, beispielsweise durch Transistoren schaltbar, vorzusehen. Dementsprechend lassen sich beispielsweise zwei oder mehr verschiedene interne Schaltkonfigurationen einstellen, wobei in jeder eingestellten Schaltkonfiguration vorzugsweise eines der zuvor beschriebenen Ausführungsbeispiele implementiert ist. Somit lässt sich das Betriebsverhalten des Hall-Sensors umschalten. Hierfür ist beispielsweise eine Schaltmatrix mit einer entsprechenden Anzahl an Transistoren vorgesehen, welche den Hall-Sensor von einer ersten internen Schaltkonfiguration in eine zweite interne Schaltkonfiguration umschalten können.

Bei einigen der zuvor beschriebenen Ausführungsformen von Hall-Sensoren mit mehreren Hall-Sensorelementen ist der jeweilige Hall-Sensor aus mindestens drei Hall-Sensorelementen gebildet. Ferner weist jedes der Hall-Sensorelemente drei Elementanschlüsse bei dreieckigen Hall-Sensorelementen, oder vier oder mehr Elementanschlüsse bei quadratischen oder rechteckigen Hall-Sensorelementen auf. Die Anzahl von wenigstens drei Elementanschlüssen der verwendeten Hall-Sensorelemente gilt auch für die vertikalen Hall-Sensorelemente. Die Sensoranschlüsse der beschriebenen Hall-Sensoren sind jeweils mit zumindest einem der Hall-Sensorelemente an wenigstens einem von dessen Elementanschlüssen verbunden. Weiterhin ist bei wenigstens zwei der Hall-Sensorelemente oder bei allen der Hall-Sensorelemente wenigstens ein Elementanschluss, der nicht mit einem Sensoranschluss verbunden ist, mit genau einem Elementanschluss eines anderen, insbesondere benachbarten Hall-Sensorelements verbunden, der wiederum nicht mit einem Sensoranschluss verbunden ist. Vorzugsweise sind höchstens zwei Elementanschlüsse eines jeden Hall-Sensorelements jeweils mit einem der Sensoranschlüsse verbunden.

Vorzugsweise sind bei allen der zuvor beschriebenen Ausführungsformen von Hall-Sensoren mit mehreren Hall-Sensorelementen die jeweiligen Hall-Sensorelemente in einem Gitter mit einer mehr als eindimensionalen Struktur bzw. in einem Array mit mehr als einer Zeile und mehr als einer Spalte verschaltet.

Figur 27 zeigt beispielhaft das Layout eines Hall-Sensors mit einem 64 x 64 Gitter aus vertikalen Hall-Sensorelementen, die entsprechend dem oben beschriebenen Prinzip miteinander verschaltet sind. Der Hall-Sensor weist vier Sensoranschlüsse EXT_A, EXT_B, EXT_C, EXT_D auf. In Figur 27 ist zudem ein Ausschnitt aus dem Gitter vergrößert dargestellt, bei dem die einzelnen vertikalen Hall-Sensorelemente deutlicher zu erkennen sind. Insbesondere kann man sehen, dass die einzelnen Hall-Sensorelemente mit fünf Elementanschlüssen ausgebildet sind, wie beispielsweise exemplarisch in Figur 3B dargestellt.

In der dargestellten Ausführungsform wird insbesondere ein magnetisches Feld parallel zur Oberfläche des Halbleiterkörpers gemessen, welches zudem senkrecht zu der längeren Seite der rechteckförmigen Fläche des Hall-Sensors verläuft.

In weiteren Ausführungsformen können auch zwei Hall-Sensoren mit jeweils mehreren vertikalen Hall-Sensorelementen derart kombiniert werden, dass auf einer gemeinsamen Fläche sowohl die Hall-Sensorelemente des einen Hall-Sensors als auch die Hall-Sensorelemente des anderen Hall-Sensors angeordnet sind, wobei die vertikalen Hall-Sensorelemente des einen Hall-Sensors einen Winkel, insbesondere um 90°, gegenüber den vertikalen Hall-Sensorelementen des anderen Hall-Sensors verdreht sind. Somit kann auf der räumlich gleichen Fläche des Halbleiterkörpers eine Messung von orthogonalen Magnetfeldkomponenten parallel zur Oberfläche des Halbleiterkörpers gemessen werden.

In den zuvor dargestellten Ausführungsformen sind überwiegend einzelne mögliche Modifikationen und Abwandlungen getrennt voneinander dargestellt und beschrieben worden. Jedoch lassen sich die verschiedenen einzelnen Abwandlungen und Ausgestaltungen beliebig miteinander kombinieren. Dadurch können vielfältige Ausgestaltungen von Hall-Sensoren erreicht werden, die jeweils günstige Eigenschaften bezüglich einer Offset-Spannung beziehungsweise Restoffset-Spannung aufweisen und sich durch eine hohe Genauigkeit beziehungsweise Empfindlichkeit bei der Magnetfeldmessung auszeichnen.

## Patentansprüche

1. Hall-Sensor mit wenigstens drei Hall-Sensorelementen (1, 2, ..., 94), insbesondere gleichartigen Hall-Sensorelementen, die jeweils wenigstens drei Elementanschlüsse (A, B, C, D, E, F, G, H) aufweisen und in einem Schaltungsgitter mit einer mehr als eindimensionalen Struktur verschaltet sind, und mit wenigstens drei Sensoranschlüssen (EXT_A, EXT_B, EXT_C, EXT_D) zur Kontaktierung des Hall-Sensors,
**gekennzeichnet dadurch dass** der Hall-Sensor so eingerichtet ist, dass
- die wenigstens drei verschalteten Hall-Sensorelemente (1, 2, ..., 94) über die Sensoranschlüsse (EXT_A, EXT_B, EXT_C, EXT_D) wie ein einzelner Hall-Sensor kontaktierbar sind;
- jeder Sensoranschluss (EXT_A, EXT_B, EXT_C, EXT_D) mit zumindest einem der Hall-Sensorelemente (1, 2, ..., 94) an einem von dessen Elementanschlüssen (A, B, C, D, E, F, G, H) verbunden ist; und
- wenigstens ein Elementanschluss (A, B, C, D, E, F, G, H) eines jeden Hall-Sensorelements (1, 2, ..., 94) jeweils nicht mit einem der Sensoranschlüsse (EXT_A, EXT_B, EXT_C, EXT_D) verbunden ist.

2. Hall-Sensor nach Anspruch 1,
bei dem in jeder möglichen Kombination von jeweils zwei der Sensoranschlüsse (EXT_A, EXT_B, EXT_C, EXT_D) wenigstens ein Signalpfad zwischen diesen zwei Sensoranschlüssen gebildet ist, bei dem eine Anzahl von Hall-Sensorelementen (1, 2, ..., 94), die in diesem Signalpfad verbunden sind, kleiner als die Anzahl der Hall-Sensorelemente (1, 2, ..., 94) des Hall-Sensors ist.

3. Hall-Sensor nach Anspruch 1 oder 2,
bei dem bei wenigstens zwei der Hall-Sensorelemente (1, 2, ..., 94) wenigstens ein Elementanschluss (A, B, C, D, E, F, G, H), der nicht mit einem Sensoranschluss (EXT_A, EXT_B, EXT_C, EXT_D) verbunden ist, mit einem anderen Hall-Sensorelement (1, 2, ..., 94) an genau einem von dessen Elementanschlüssen (A, B, C, D, E, F, G, H) verbunden ist, der nicht mit einem Sensoranschluss (EXT_A, EXT_B, EXT_C, EXT_D) verbunden ist.

4. Hall-Sensor nach einem der Ansprüche 1 bis 3,
bei dem die Hall-Sensorelemente (1, 2, ..., 94) innerhalb einer definierten Flächenform angeordnet sind.

5. Hall-Sensor nach Anspruch 4,
bei dem die Flächenform wenigstens eine Symmetriebeziehung und eine der folgenden Formen aufweist:
- eine Rechteckform;
- eine quadratische Form;
- eine Kreuzform;
- eine Kreisform;
- die Form eines geraden Vielecks, insbesondere eines Sechsecks oder eines Achtecks.

6. Hall-Sensor nach Anspruch 4 oder 5,
bei dem die Hall-Sensorelemente (1, 2, ..., 94), die mit den Sensoranschlüssen (EXT_A, EXT_B, EXT_C, EXT_D) verbunden sind, jeweils an den Außenrand der Fläche angrenzend angeordnet sind.

7. Hall-Sensor nach einem der Ansprüche 4 bis 6,
bei dem die Hall-Sensorelemente (1, 2, ..., 94), die nicht an den Außenrand der Fläche angrenzend angeordnet sind, an allen ihren Elementanschlüssen (A, B, C, D, E, F, G, H) jeweils mit genau einem Elementanschluss (A, B, C, D, E, F, G, H) eines benachbarten Hall-Sensorelements (1, 2, ..., 94) verbunden sind.

8. Hall-Sensor nach Anspruch 7,
bei dem die Hall-Sensorelemente (1, 2, ..., 94), die nicht an den Außenrand der Fläche angrenzend angeordnet sind, an den einzelnen Elementanschlüssen (A, B, C, D, E, F, G, H) mit jeweils verschiedenen benachbarten Hall-Sensorelementen (1, 2, ..., 94) verbunden sind.

9. Hall-Sensor nach einem der Ansprüche 1 bis 8,
bei dem jeweils wenigstens eine Verbindung von einem der Sensoranschlüsse (EXT_A,
EXT B, EXT C, EXT_D) zu einem der Elementanschlüsse (A, B, C, D, E, F, G, H) eine feste Verbindung ist.

10. Hall-Sensor nach Anspruch 9,
bei dem zusätzlich zu der festen Verbindung die Sensoranschlüsse (EXT_A, EXT_B, EXT_C, EXT_D) jeweils wenigstens eine schaltbare Verbindung zu wenigstens einem anderen der Hall-Sensorelemente (1, 2, ..., 94) an einem von dessen Elementanschlüssen (A, B, C, D, E, F, G, H) aufweisen.

11. Hall-Sensor nach einem der Ansprüche 1 bis 10,
bei dem die Hall-Sensorelemente (1, 2, ..., 94) gleichartig aufgebaut sind und jeweils wenigstens vier Elementanschlüsse (A, B, C, D) aufweisen, die durch ein erstes Paar von Elementanschlüssen (A, C) und wenigstens ein zweites Paar von Elementanschlüssen (B, D) gebildet sind, wobei bei zumindest einem Teil der Hall-Sensorelemente (1, 2, ..., 94)
- ein erster Elementanschluss des ersten Paars eines Hall-Sensorelements (1, 2, ..., 94) mit einem der Elementanschlüsse des zweiten Paars eines anderen, insbesondere benachbarten Hall-Sensorelements (1, 2, ..., 94) verbunden ist; und
- ein erster Elementanschluss des zweiten Paars dieses Hall-Sensorelements (1, 2, ..., 94) mit einem der Elementanschlüsse des ersten Paars eines weiteren anderen, insbesondere benachbarten Hall-Sensorelements (1, 2, ..., 94) verbunden ist.

12. Hall-Sensor nach einem der Ansprüche 1 bis 10,
bei dem die Hall-Sensorelemente (1, 2, ..., 94) gleichartig aufgebaut sind und jeweils wenigstens vier Elementanschlüsse (A, B, C, D) aufweisen, die durch ein erstes Paar von Elementanschlüssen (A, C) und wenigstens ein zweites Paar von Elementanschlüssen (B, D) gebildet sind, wobei bei zumindest einem Teil der Hall-Sensorelemente (1, 2, ..., 94)
- ein erster Elementanschluss des ersten Paars eines Hall-Sensorelements (1, 2, ..., 94) mit einem zweiten Elementanschluss des ersten Paars eines anderen, insbesondere benachbarten Hall-Sensorelements (1, 2, ..., 94) verbunden ist; und
- ein erster Elementanschluss des zweiten Paars dieses Hall-Sensorelements (1, 2, ..., 94) mit einem zweiten Elementanschluss des zweiten Paars eines weiteren anderen, insbesondere benachbarten Hall-Sensorelements (1, 2, ..., 94) verbunden ist.

13. Hall-Sensor nach Anspruch 12,
bei dem alle Hall-Sensorelemente (1, 2, ..., 94) bezüglich der Ausrichtung des ersten und zweiten Paars eine gleiche Orientierung aufweisen.

14. Hall-Sensor nach Anspruch 12,
bei dem die Hall-Sensorelemente (1, 2, ..., 94) bezüglich der Ausrichtung des ersten und zweiten Paars zumindest teilweise eine voneinander abweichende Orientierung aufweisen.

15. Hall-Sensor nach einem der Ansprüche 1 bis 14,
bei dem jedes Hall-Sensorelement (1, 2, ..., 94) genau ein Hall-Sensorelement oder eine Kombination mehrerer verschalteter Hall-Sensorelemente umfasst.

## Claims

1. A Hall sensor comprising at least three Hall sensor elements (1, 2, ..., 94), in particular identical Hall sensor elements which each comprise at least three element terminals (A, B, C, D, E, F, G, H) and are interconnected in a circuit grid having a structure which is of higher order than one-dimensional, and comprising at least three sensor terminals (EXT_A, EXT_B, EXT_C, EXT_D) for contacting the Hall sensor, **characterized in that** the Hall sensor is arranged such that
- the at least three interconnected Hall sensor elements (1, 2, ..., 94) can be contacted via the sensor terminals (EXT_A, EXT_B, EXT_C, EXT_D) like a single Hall sensor;
- each sensor terminal (EXT_A, EXT_B, EXT_C, EXT_D) is connected to at least one of the Hall sensor elements (1, 2, ..., 94) at one of its element terminals (A, B, C, D, E, F, G, H); and
- at least one element terminal (A, B, C, D, E, F, G, H) of each of the Hall sensor elements (1, 2, ..., 94) is respectively not connected to one of the sensor terminals (EXT_A, EXT_B, EXT_C, EXT_D).

2. The Hall sensor according to claim 1,
in which in each possible combination of respectively two of the sensor terminals (EXT_A, EXT_B, EXT_C, EXT_D), at least one signal path is formed between said two sensor terminals, in which a number of Hall sensor elements (1, 2, ..., 94) which are connected in said signal path is smaller than the number of the Hall sensor elements (1, 2, ..., 94) of the Hall sensor.

3. The Hall sensor according to claim 1 or 2,
in which in at least two of the Hall sensor elements (1, 2, ..., 94), at least one element terminal (A, B, C, D, E, F, G, H) not connected to a sensor terminal (EXT_A, EXT_B, EXT_C, EXT_D) is connected to another Hall sensor element (1, 2, ..., 94) at exactly one of its element terminals (A, B, C, D, E, F, G, H), which is not connected to a sensor terminal (EXT_A, EXT_B, EXT_C, EXT_D).

4. The Hall sensor according to any of claims 1 to 3, in which the Hall sensor elements (1, 2, ..., 94) are arranged within a defined areal shape.

5. The Hall sensor according to claim 4,
in which the areal shape comprises at least one relation of symmetry and one of the following shapes:
- a rectangular shape;
- a square shape;
- a cross shape;
- a circular shape;
- the shape of an even polygon, in particular of a hexagon or of an octagon.

6. The Hall sensor according to claim 4 or 5,
in which the Hall sensor elements (1, 2, ..., 94) not connected to the sensor terminals (EXT_A, EXT_B, EXT_C, EXT_D) are arranged in each case so as to be adjacent to the outer edge of the surface area.

7. The Hall sensor according to any of claims 4 to 6,
in which the Hall sensor elements (1, 2, ..., 94) arranged so as to be not adjacent to the outer edge of the surface area have all their element terminals (A, B, C, D, E, F, G, H) connected to exactly one element terminal (A, B, C, D, E, F, G, H) of a neighboring Hall sensor element (1, 2, ..., 94).

8. The Hall sensor according to claim 7,
in which the Hall sensor elements (1, 2, ..., 94) arranged so as to be not adjacent to the outer edge of the surface area have their individual element terminals (A, B, C, D, E, F, G, H) connected to different neighboring Hall sensor elements (1, 2, ..., 94) in each case.

9. The Hall sensor according to any of claims 1 to 8,
in which at least one connection from one of the sensor terminals (EXT_A, EXT_B, EXT_C, EXT_D) to one of the element terminals (A, B, C, D, E, F, G, H) is a fixed connection in each case.

10. The Hall sensor according to claim 9,
in which, in addition to the fixed connection, the sensor terminals (EXT_A, EXT_B, EXT_C, EXT_D) each comprise at least one switchable connection to at least one other of the Hall sensor elements (1, 2, ..., 94) at one of its element terminals (A, B, C, D, E, F, G, H).

11. The Hall sensor according to any of claims 1 to 10,
in which the Hall sensor elements (1, 2, ..., 94) are of identical construction and each comprise at least four element terminals (A, B, C, D) which are formed by a first pair of element terminals (A, C) and at least one second pair of element terminals (B, D), wherein in at least some of the Hall sensor elements (1, 2, ..., 94)
- a first element terminal of the first pair of a Hall sensor element (1, 2, ..., 94) is connected to one of the element terminals of the second pair of another, in particular neighboring Hall sensor element (1,2, ..., 94); and
- a first element terminal of the second pair of said Hall sensor element (1, 2, ..., 94) is connected to one of the element terminals of the first pair of still another, in particular neighboring Hall sensor element (1, 2, ..., 94).

12. The Hall sensor according to any of claims 1 to 10,
in which the Hall sensor elements (1, 2, ..., 94) are of identical construction and each comprise at least four element terminals (A, B, C, D) which are formed by a first pair of element terminals (A, C) and at least one second pair of element terminals (B, D), wherein in at least some of the Hall sensor elements (1, 2, ..., 94)
- a first element terminal of the first pair of a Hall sensor element (1, 2, ..., 94) is connected to a second element terminal of the first pair of another, in particular neighboring Hall sensor element (1, 2, ..., 94); and
- a first element terminal of the second pair of said Hall sensor element (1, 2, ..., 94) is connected to a second element terminal of the second pair of still another, in particular neighboring Hall sensor element (1, 2, ..., 94).

13. The Hall sensor according to claim 12,
in which all of the Hall sensor elements (1, 2, ..., 94) have the same orientation with respect to the alignment of the first and second pairs.

14. The Hall sensor according to claim 12,
in which the Hall sensor elements (1, 2, ..., 94) at least partially have deviating orientations with respect to the alignment of the first and second pairs.

15. The Hall sensor according to any of claims 1 to 14,
in which each Hall sensor element (1, 2, ..., 94) comprises exactly one Hall sensor element or a combination of a plurality of interconnected Hall sensor elements.

## Revendications

1. Capteur de Hall comportant au moins trois éléments de capteur de Hall (1, 2, ..., 94), en particulier des éléments de capteur de Hall de même type, qui présentent respectivement au moins trois connexions d'élément (A, B, C, D, E, F, G, H) et sont interconnectés dans une grille de circuit ayant une structure plus qu'unidimensionnelle, et comportant au moins trois connexions de capteur (EXT_A, EXT_B, EXT_C, EXT_D) pour la mise en contact du capteur de Hall,
**caractérisé en ce que** le capteur de Hall est configuré de telle sorte que
- les au moins trois éléments de capteur de Hall interconnectés (1, 2, ..., 94) sont contactables comme un seul capteur de Hall via les connexions de capteur (EXT_A, EXT_B, EXT_C, EXT_D);
- chaque connexion de capteur (EXT_A, EXT_B, EXT_C, EXT_D) est reliée à au moins un des éléments de capteur de Hall (1, 2, ..., 94) par une de ses connexions d'élément (A, B, C, D, E, F, G, H); et
- au moins une connexion d'élément (A, B, C, D, E, F, G, H) de chaque élément de capteur de Hall (1, 2, ..., 94) n'est respectivement pas reliée à une des connexions de capteur (EXT_A, EXT_B, EXT_C, EXT_D).

2. Capteur de Hall selon la revendication 1,
dans lequel, dans chaque combinaison possible de respectivement deux des connexions de capteur (EXT_A, EXT_B, EXT_C, EXT_D), au moins un chemin de signal est formé entre ces deux connexions de capteur, pour lequel un nombre d'éléments de capteur de Hall (1, 2, ..., 94) qui sont reliés dans ce chemin de signal est plus petit que le nombre d'éléments de capteur de Hall (1, 2, ..., 94) du capteur de Hall.

3. Capteur de Hall selon la revendication 1 ou 2,
dans lequel, pour au moins deux des éléments de capteur de Hall (1, 2, ..., 94), au moins une connexion d'élément (A, B, C, D, E, F, G, H) qui n'est pas reliée à une connexion de capteur (EXT_A, EXT_B, EXT_C, EXT_D) est reliée à un autre élément de capteur de Hall (1, 2, ..., 94) par exactement une de ses connexions d'élément (A, B, C, D, E, F, G, H) qui n'est pas reliée à une connexion de capteur (EXT_A, EXT_B, EXT_C, EXT_D).

4. Capteur de Hall selon l'une des revendications 1 à 3, dans lequel les éléments de capteur de Hall (1, 2, ..., 94) sont disposés au sein d'une forme de surface définie.

5. Capteur de Hall selon la revendication 4,
dans lequel la forme de surface présente au moins un rapport de symétrie et une des formes suivantes:
- une forme rectangulaire;
- une forme carrée;
- une forme de croix;
- une forme de cercle;
- la forme d'un polygone droit, en particulier d'un hexagone ou d'un octogone.

6. Capteur de Hall selon la revendication 4 ou 5,
dans lequel les éléments de capteur de Hall (1, 2, ..., 94) qui sont reliés aux connexions de capteur (EXT_A, EXT_B, EXT_C, EXT_D) sont disposés respectivement de manière limitrophe au bord extérieur de la surface.

7. Capteur de Hall selon l'une des revendications 4 à 6,
dans lequel les éléments de capteur de Hall (1, 2, ..., 94) qui ne sont pas disposés de manière limitrophe au bord extérieur de la surface sont reliés, par toutes leurs connexions d'élément (A, B, C, D, E, F, G, H), respectivement à exactement une connexion d'élément (A, B, C, D, E, F, G, H) d'un élément de capteur de Hall (1, 2, ..., 94) voisin.

8. Capteur de Hall selon la revendication 7,
dans lequel les éléments de capteur de Hall (1, 2, ..., 94) qui ne sont pas disposés de manière limitrophe au bord extérieur de la surface sont reliés, par les différentes connexions d'élément (A, B, C, D, E, F, G, H), à respectivement divers éléments de capteur de Hall (1, 2, ..., 94) voisins.

9. Capteur de Hall selon l'une des revendications 1 à 8,
dans lequel respectivement au moins une liaison d'une des connexions de capteur (EXT_A, EXT_B, EXT_C, EXT_D) à une des connexions d'élément (A, B, C, D, E, F, G, H) est une liaison fixe.

10. Capteur de Hall selon la revendication 9,
dans lequel, en plus de la liaison fixe, les connexions de capteur (EXT_A, EXT_B, EXT_C, EXT_D) présentent respectivement au moins une liaison commutable à au moins un autre des éléments de capteur de Hall (1, 2, ..., 94) par une de ses connexions d'élément (A, B, C, D, E, F, G, H).

11. Capteur de Hall selon l'une des revendications 1 à 10,
dans lequel les éléments de capteur de Hall (1, 2, ..., 94) sont structurés de même manière et présentent respectivement au moins quatre connexions d'élément (A, B, C, D) qui sont formées par une première paire de connexions d'élément (A, C) et au moins une deuxième paire de connexions d'élément (B, D), sachant que pour au moins une partie des éléments de capteur de Hall (1, 2, ..., 94)
- une première connexion d'élément de la première paire d'un élément de capteur de Hall (1, 2, ..., 94) est reliée à une des connexions d'élément de la deuxième paire d'un autre élément de capteur de Hall (1, 2, ..., 94), en particulier voisin; et
- une première connexion d'élément de la deuxième paire de cet élément de capteur de Hall (1, 2, ..., 94) est reliée à une des connexions d'élément de la première paire d'un autre élément de capteur de Hall supplémentaire (1, 2, ..., 94), en particulier voisin.

12. Capteur de Hall selon l'une des revendications 1 à 10,
dans lequel les éléments de capteur de Hall (1, 2, ..., 94) sont structurés de même manière et présentent respectivement au moins quatre connexions d'élément (A, B, C, D) qui sont formées par une première paire de connexions d'élément (A, C) et au moins une deuxième paire de connexions d'élément (B, D), sachant que pour au moins une partie des éléments de capteur de Hall (1, 2, ..., 94)
- une première connexion d'élément de la première paire d'un élément de capteur de Hall (1, 2, ..., 94) est reliée à une deuxième connexion d'élément de la première paire d'un autre élément de capteur de Hall (1, 2, ..., 94), en particulier voisin; et
- une première connexion d'élément de la deuxième paire de cet élément de capteur de Hall (1, 2, ..., 94) est reliée à une deuxième connexion d'élément de la deuxième paire d'un autre élément de capteur de Hall supplémentaire (1, 2, ..., 94), en particulier voisin.

13. Capteur de Hall selon la revendication 12,
dans lequel tous les éléments de capteur de Hall (1, 2, ..., 94) présentent une même orientation eu égard à l'alignement de la première et de la deuxième paire.

14. Capteur de Hall selon la revendication 12,
dans lequel les éléments de capteur de Hall (1, 2, ..., 94) présentent au moins en partie une orientation différente l'une de l'autre eu égard à l'alignement de la première et de la deuxième paire.

15. Capteur de Hall selon l'une des revendications 1 à 14,
dans lequel chaque élément de capteur de Hall (1, 2, ..., 94) comprend exactement un élément de capteur de Hall ou une combinaison de plusieurs éléments de capteur de Hall interconnectés.
